# EUROPÄISCHE PATENTSCHRIFT

(11) **EP 4 234 156 B1**
(45) Veröffentlichungstag und Bekanntmachung des Hinweises auf die Patenterteilung: **29.10.2025**
(21) Anmeldenummer: 23168690.8
(22) Anmeldetag: 27.11.2015
(51) Int. Cl.: B23K 26/00, B23K 26/402, H01L 21/78, B28D 5/00, B23K 26/40, B23K 26/53, B23K 103/00, B23K 101/40

(54) **LASERBASIERTES TRENNVERFAHREN**
LASER BASED SLICING METHOD
MÉTHODE DE SÉPARATION BASÉE SUR L'UTILISATION D'UN LASER

(30) Priorität: 27.11.2014 DE 102014017583; 27.11.2014 DE 102014017582; 17.12.2014 DE 102014018720; 17.12.2014 DE 102014018841
(43) Veröffentlichungstag der Anmeldung: 30.08.2023
(62) Teilanmeldung aus: 15804372.9
(73) Patentinhaber: Siltectra GmbH, 01099 Dresden (DE)
(72) Erfinder: BEYER, Christian, 09599 Freiberg (DE); RICHTER, Jan, 01277 Dresden (DE)
(74) Vertreter: Müller Hoffmann & Partner

(56) Entgegenhaltungen:
- WO-A1-2013/115352
- WO-A2-2013/126927
- US-A- 5 968 382

## Beschreibung

Die vorliegende Erfindung bezieht sich gemäß den Ansprüchen 1 und 2 auf Verfahren zum Erzeugen eines Ablösebereichs in einem Festkörper und gemäß den Ansprüchen 8 und 9 auf Verfahren zum zumindest teilweisen Teilen eines Festkörpers.

Das Teilen von Festkörpern, insbesondere von Wafern, wird klassisch durch Sägen bewirkt. Dieses Trennverfahren hat jedoch eine Vielzahl an Nachteile. So werden beim Sägen stets Späne erzeugt, die somit zerstörtes Grundmaterial darstellen. Ferner nimmt die Dickenschwankung der abgesägten Scheiben bei einer Zunahme der Sägehöhe ebenfalls zu. Weiterhin bewirkt das Sägeelement, dass auf den Oberflächen der voneinander zu trennenden Scheiben Riefen entstehen.

Es ist daher ersichtlich, dass das Trennverfahren "Sägen" sehr hohe Materialkosten und Kosten für die Nacharbeit bedingt.

Ferner offenbart die Druckschrift WO 2013/126927 A2 ein Verfahren zum Abtrennen von Geräteschichten von einem Ausgangswafer. Gemäß der WO 2013/126927 A2 erfolgt dabei ein sehr starkes Aufheizen der Gesamtanordnung infolge einer Laserbeaufschlagung. Diese Aufheizung wird benötigt um über die unterschiedlichen Wärmeausdehnungskoeffizienten des Festkörpermaterials und einem "Handler" Spannungen im Inneren des Festkörpers zu erzielen. Es ist hierbei ersichtlich, dass die thermische Beanspruchbarkeit des "Handlers" sehr hoch sein muss, da sehr hohe Temperaturen auftreten. Ferner werden gemäß der WO 2013/126927 A2 die Laserstrahlen immer über eine Oberfläche in den Festkörper eingeleitet, die nicht Bestandteil der abzutrennenden Schicht ist. Dies führt ebenfalls zu einer starken Aufheizung des Festkörpers. Die hohen Temperaturen haben ebenfalls den Nachteil, dass sich der Festkörper verzieht oder ungewollt ausdehnt, wodurch die Erzeugung von Kristallgittermodifikationen nur sehr unpräzise möglich ist.

Gemäß der WO 2013/126927 A2 lassen sich somit keine dicken und großen Festkörper bearbeiten.

Es ist daher die Aufgabe der vorliegenden Erfindung ein alternatives Verfahren zum Abtrennen von Festkörperanteilen, insbesondere von mehreren Festkörperschichten, von einem Festkörper bereitzustellen. Die zuvor genannte Aufgabe wird erfindungsgemäß durch ein Verfahren gemäß Anspruch 1 gelöst. Das erfindungsgemäße Verfahren betrifft ein Verfahren zum Erzeugen eines Ablösebereichs in einem Festkörper, insbesondere zum Teilen des Festkörpers entlang des Ablösebereichs, wobei der abzulösende Festkörperanteil dünner ist als der um den Festkörperanteil reduzierte Festkörper. Erfindungsgemäß umfasst das Verfahren bevorzugt mindesten den Schritt des Modifizierens des Kristallgitters des Festkörpers mittels eines Modifiziermittels, insbesondere eines Lasers, insbesondere eines Piko- oder Femtosekunden-Lasers, wobei die Modifikationen, insbesondere die Laserstrahlen, über eine Oberfläche des abzulösenden Festkörperanteils in den Festkörper eindringen, wobei mehrere Modifikationen in dem Kristallgitter erzeugt werden, wobei das Kristallgitter in Folge der Modifikationen in den die Modifikationen umgebenden Bereichen zumindest in jeweils einem Anteil, insbesondere unterkritisch, einreist.

Diese Lösung ist vorteilhaft, da sie z.B. ohne Späne zu verursachen eine definierte Schwächung des Festkörpers ermöglicht.

Ferner schafft die vorliegende Erfindung erstmals eine Möglichkeit, dass ein Festkörper nicht orthogonal zu seiner zu kürzenden Längsrichtung gekürzt werden muss, sondern dass er mit dem LASER in seiner Längsrichtung derart beaufschlagt wird, dass eine Festkörperschicht abgetrennt wird. Dieses Verfahren hat ferner den Vorteil, dass die LASER-Strahlen nicht über den gesamten Radius des Festkörpers in den Festkörper eindringen müssen, sondern über eine zur Abtrennschicht bzw. Ablöseschicht bevorzugt parallelen Schicht in den Festkörper eingebracht werden können. Dies ist insbesondere bei Festkörpern sinnvoll, deren Radius größer oder gleich der Dicke der abzutrennenden Festkörperschicht ist.

Gemäß einer weiteren bevorzugten Ausführungsform der vorliegenden Erfindung reißt das Kristallgitter zumindest mehrheitlich jeweils in einem vom Zentrum der jeweiligen Modifikation beabstandeten Anteil ein. Diese Lösung ist besonders vorteilhaft, da hierdurch der Bedarf einer Nachbearbeitung des Teils des Festkörpers, an dem nach dem Trennen volumenmäßig weniger von der Modifikation bzw. von den Modifikationen verbleibt, reduziert wird.

Die zuvor genannte Aufgabe wird erfindungsgemäß ebenfalls durch ein Verfahren gemäß Anspruch 3 gelöst. Das weitere erfindungsgemäße Verfahren zum Erzeugen eines Ablösebereichs in einem Festkörper, insbesondere zum Teilen des Festkörpers entlang des Ablösebereichs, umfasst dabei bevorzugt mindestens die Schritte des Modifizierens des Kristallgitters des Festkörpers mittels eines Modifiziermittels, insbesondere eines Lasers, insbesondere eines Piko- oder Femtosekunden-Laser, oder eines lonenimplaniermittels, mittels dem Ionen zur Modifikation des Kristallgitters in das Kristallgitter eingebracht werden, wobei mehrere Modifikationen in dem Kristallgitter erzeugt werden, und des Konditionierens zumindest mehrerer der Modifikationen durch ein Konditioniermittel, insbesondere eine Temperierungseinrichtung, wobei das Kristallgitter durch die Konditionierung in den die Modifikation umgebenden Bereichen zumindest in jeweils einem Anteil einreist.

Die zuvor genannte Aufgabe wird erfindungsgemäß ebenfalls durch ein Verfahren gemäß Anspruch 8 gelöst. Das weitere erfindungsgemäße Verfahren zum zumindest teilweisen Teilen eines Festkörpers, umfasst einen der Gegenstände der Ansprüche 1 bis 3, wobei so viele Modifikationen in dem Kristallgitter erzeugt werden, dass sich die einzelnen Risse zu einem Hauptriss verbinden, durch den der Festkörper zumindest teilweise und bevorzugt vollständig geteilt wird.

Diese Lösung ist vorteilhaft, da sie z.B. ohne Späne zu verursachen eine definierte Teilung des Festkörpers ermöglicht.

Die zuvor genannte Aufgabe wird erfindungsgemäß ebenfalls durch ein Verfahren gemäß Anspruch 9 gelöst. Das weitere erfindungsgemäße Verfahren zum zumindest teilweisen Teilen eines Festkörpers, umfasst einen der Gegenstände der Ansprüche 1 bis 2, wobei die Modifikationen in einem ersten Abschnitt des Festkörpers erzeugt werden, wodurch sich ein durch die einzelnen, insbesondere unterkritischen, Risse erstreckender Hauptriss ausbildet, wobei nach der Ausbildung des Hauptrisses oder infolge der Ausbildung des Hauptrisses weitere Modifikationen in mindestens einem weiteren Abschnitt des Festkörpers erzeugt werden, wobei der Hauptriss durch Risse im Bereich der weiteren Modifikationen ebenfalls in den mindestens einen weiteren Abschnitt geführt wird, insbesondere bis die durch den Hauptriss voneinander zunächst lokal gelösten Festkörperanteile vollständig voneinander getrennt sind.

Diese Lösung ist vorteilhaft, da sie z.B. ohne Späne zu verursachen ebenfalls eine definierte Teilung des Festkörpers ermöglicht.

Unterkritisch bedeutet hierbei bevorzugt, dass die Rissausbreitung zum Erliegen kommt bzw. stoppt bevor der Riss den Festkörper in mindestens zwei Teile teilt. Bevorzugt breitet sich ein unterkritischer Riss weniger als 5mm, insbesondere weniger als 1mm, in dem Festkörper aus. Die Modifikationen werden bevorzugt derart erzeugt, dass sich z.B. beim Abtrennen von ebenen Festkörperplatten die unterkritischen Risse bevorzugt mehrheitlich in derselben Ebene ausbreiten, insbesondere in einer zur Oberfläche des Festkörpers, durch welche die Laserstrahlen in den Festkörper eindringen, parallelen oder definiert ausgerichteten Ebene ausbreiten. Die Modifikationen werden bevorzugt derart erzeugt, dass sich z.B. beim Abtrennen von unebenen Festkörpern die unterkritischen Risse bevorzugt derart definiert, z.B. in einer sphärischen Lage bzw. Schicht ausbreiten, dass der Ablösebereich eine definierte, insbesondere sphärische, Form erhält.

Der Festkörper ist bevorzugt ein Ingot oder ein Wafer. Besonders bevorzugt handelt es sich bei dem Festkörper um ein für Laserstrahlen zumindest teilweise transparentes Material. Es ist somit weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können. Ferner kann der Festkörper zusätzlich oder alternativ Siliziumcarbid (SiC) aufweisen oder daraus bestehen.

Gemäß einer weiteren bevorzugten Ausführungsform der vorliegenden Erfindung wird die Energie des Laserstrahls des Lasers, insbesondere fs-Lasers (Femtosekundenlaser), derart gewählt, dass die Schädigungsausbreitung im Festkörper bzw. im Kristall kleiner als dreimal die Reyleighlänge, bevorzugt kleiner als die Reyleighlänge und besonders bevorzugt kleiner als ein Drittel der Reyleighlänge ist.

Das Kristallgitter reist gemäß einer weiteren bevorzugten Ausführungsform der vorliegenden Erfindung zumindest mehrheitlich in einem vom Zentrum Z der jeweiligen Modifikation beabstandeten Anteil ein.

Der Riss geht gemäß einer weiteren bevorzugten Ausführungsform der vorliegenden Erfindung zumindest abschnittsweise durch die Mehrzahl, insbesondere die Gesamtheit, der Modifikationen hindurch oder verläuft zumindest zu der Mehrzahl, insbesondere zu der Gesamtheit, der Modifikationen beabstandet.

Eine erste Anzahl an Modifikationen wird gemäß einer weiteren bevorzugten Ausführungsform der vorliegenden Erfindung mit ihrem Zentrum Z einerseits des Ablösebereichs erzeugt und eine zweite Anzahl an Modifikationen wird mit ihrem Zentrum andererseits des Ablösebereichs erzeugt.

Die Modifikationen werden gemäß einer weiteren bevorzugten Ausführungsform der vorliegenden Erfindung mittels Laser erzeugt, wobei die Pulsabstände zwischen 0,01 µm und 10 µm vorgesehen werden und/oder Linienabstände zwischen 0,01 µm und 20 µm vorgesehen werden und/oder eine Pulswiederholfrequenz zwischen 16kHz und 1024kHz vorgesehen wird.

Die Wellenlänge des Laserstrahls des Lasers, insbesondere des fs-Lasers, wird gemäß einer weiteren bevorzugten Ausführungsform der vorliegenden Erfindung derart gewählt, dass die Absorption des Festkörpers bzw. des Materials kleiner als 10cm⁻¹ und bevorzugt kleiner als 1cm⁻¹ und besonders bevorzugt kleiner als 0,1cm⁻¹ ist.

Die einzelnen Modifikationen bzw. Defekte bzw. Schadstellen resultieren gemäß einer weiteren bevorzugten Ausführungsform der vorliegenden Erfindung jeweils aus einer von dem Laser, insbesondere fs-Laser, bewirkten multi-photonen Anregung.

Der Festkörper ist gemäß einer weiteren bevorzugten Ausführungsform der vorliegenden Erfindung über eine Festkörperoberfläche mit einer Kühleinrichtung verbunden, wobei die Festkörperoberfläche, die mit der Kühleinrichtung verbunden ist, parallel oder im Wesentlichen parallel zu der Oberfläche ausgebildet ist, über welche die Laserstrahlen in den Festkörper eindringen, wobei die Kühleinrichtung in Abhängigkeit von der Laserbeaufschlagung, insbesondere in Abhängigkeit von der sich durch die Laserbeaufschlagung ergebenden Temperierung des Festkörpers, betrieben wird. Besonders bevorzugt liegt die Oberfläche, über die der Festkörper mit der Kühleinrichtung verbunden ist, genau gegenüber von der Oberfläche, über welche die Laserstrahlen in den Festkörper eindringen. Diese Ausführungsform ist vorteilhaft, da eine beim Erzeugen der Modifikationen erfolgende Temperaturzunahme des Festkörpers begrenzt oder reduziert werden kann. Bevorzugt wird die Kühleinrichtung derart betrieben, dass der durch die Laserstrahlen in den Festkörper eingebrachte Wärmeeintrag durch die Kühleinrichtung aus dem Festkörper entzogen wird. Dies ist vorteilhaft, da dadurch signifikant das Auftreten von thermisch induzierten Spannungen oder Verformungen reduziert werden kann.

Die Kühleinrichtung weist gemäß einer weiteren bevorzugten Ausführungsform der vorliegenden Erfindung mindestens eine Sensoreinrichtung zum Erfassen der Temperatur des Festkörpers auf und bewirkt in Abhängigkeit eines vorgegebenen Temperaturverlaufs eine Abkühlung des Festkörpers. Diese Ausführungsform ist vorteilhaft, da durch die Sensoreinrichtung sehr präzise eine Temperaturveränderung des Festkörpers erfasst werden kann. Bevorzugt wird die Veränderung der Temperatur als Dateninput zur Ansteuerung der Kühleinrichtung verwendet.

Die Kühleinrichtung ist gemäß einer weiteren bevorzugten Ausführungsform der vorliegenden Erfindung an einer Rotationseinrichtung angekoppelt und die Kühleinrichtung wird mit dem daran angeordneten Festkörper während der Modifikationserzeugung mittels der Rotationseinrichtung rotiert, insbesondere mit mehr als 100 Umdrehungen pro Minute oder mit mehr als 200 Umdrehungen pro Minute oder mit mehr als 500 Umdrehungen.

Gemäß einer weiteren bevorzugten Ausführungsform der vorliegenden Erfindung ist in zumindest zwei unterschiedlichen Bereichen des Festkörpers die Anzahl der erzeugten Modifikationen je cm² verschieden, wobei in einem ersten Bereich ein erster Block an Modifikationslinien erzeugt wird, wobei die einzelnen Modifikationen je Linie bevorzugt weniger als 10 µm, insbesondere weniger als 5 µm oder weniger als 3 µm oder weniger als 1 µm oder weniger als 0,5 µm, voneinander beabstandet erzeugt werden und die einzelnen Linien des ersten Blocks weniger als 20 µm, insbesondere weniger als 15 µm oder weniger als 10 µm oder weniger als 5 µm oder weniger als 1 µm, voneinander beabstandet erzeugt werden, wobei durch den ersten Bock an Modifikationen ein erster Teilablösebereich ausgebildet wird und in einem zweiten Bereich wird ein zweiter Block an Modifikationslinien erzeugt, wobei die einzelnen Modifikationen je Linie bevorzugt weniger als 10 µm, insbesondere weniger als 5 µm oder weniger als 3 µm oder weniger als 1 µm oder weniger als 0,5 µm, voneinander beabstandet erzeugt werden und die einzelnen Linien des zweiten Blocks weniger als 20 µm, insbesondere weniger als 15 µm oder weniger als 10 µm oder weniger als 5 µm oder weniger als 1 µm, voneinander beabstandet erzeugt werden, wobei durch den zweiten Bock an Modifikationen ein zweiter Teilablösebereich ausgebildet wird, wobei der erste Bereich und der zweite Bereich durch einen dritten Bereich voneinander beabstandet sind, wobei in dem dritten Bereich keine oder im Wesentlichen keine Modifikationen mittels Laserstrahlen erzeugt werden und der erste Bereich zum zweiten Bereich um mehr als 20 µm, insbesondere mehr als 50 µm oder mehr als 100 µm oder mehr als 150 µm oder mehr als 200 µm, beabstandet ist. Diese Ausführungsform ist vorteilhaft, da durch die lokale Erzeugung von Modifikationsblöcken derart große mechanische Spannungen in dem Festkörper erzeugt werden können, dass ein lokales Einreißen des Festkörpers erfolgen kann. Es wurde erkannt, dass die Modifikationsblöcke bewirken, dass ein Riss auch in einem Bereich zwischen zwei Modifikationsblöcken stabil geführt wird. Dank der Modifikationsblöcke kann eine kontrollierte und sehr präzise Rissausbreitung mit weniger Modifikationen bewirkt werden. Dies hat erhebliche Vorteile, da die Bearbeitungszeit verkürzt wird, der Energieverbrauch reduziert wird und die Aufheizung des Festkörpers reduziert wird.

Bevorzugt werden die Modifikationen im ersten Block in Pulsabstände zwischen 0,01 µm und 10 µm erzeugt und/oder es werden Linienabstände zwischen 0,01 µm und 20 µm vorgesehen und/oder es wird eine Pulswiederholfrequenz zwischen 16kHz und 20 MHz vorgesehen.

Weitere Vorteile, Ziele und Eigenschaften der vorliegenden Erfindung werden anhand nachfolgender Beschreibung anliegender Zeichnungen erläutert, in welchen beispielhaft das erfindungsgemäße Trennverfahren dargestellt ist. Bauteile oder Elemente, die in dem erfindungsgemäßen Verfahren bevorzugt eingesetzt werden und/oder welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:

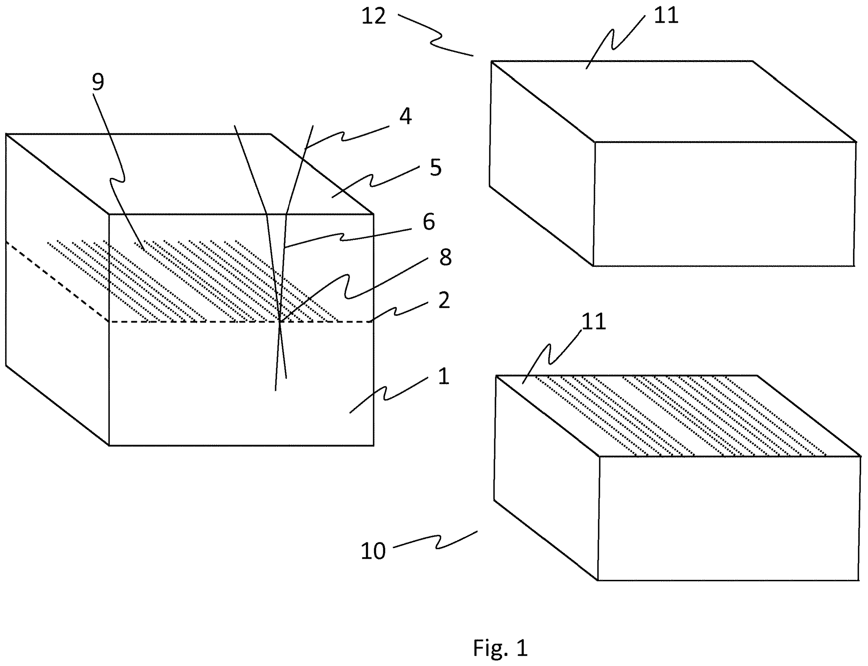

- Fig. 1: einen Festkörper während der erfindungsgemäßen Behandlung sowie die zwei Teile des Festkörpers nachdem sie voneinander getrennt wurden;
- Fig. 2a-2c: mikroskopische Aufnahmen von Kristallgittermodifikationen;
- Fig. 3a-3b: weitere mikroskopische Aufnahmen von Kristallgittermodifikationen;
- Fig. 4a-4b: noch weitere mikroskopische Aufnahmen von Kristallgittermodifikationen;
- Fig. 5a-5f: schematische Darstellungen von Modifikationen sowie dem Ablösebereich;
- Fig. 6a-6d: weitere schematische Darstellung von Modifikationen sowie dem Ablösebereich;
- Fig. 7a-7d: noch weitere schematische Darstellung von Modifikationen sowie dem Ablösebereich;
- Fig. 8: eine schematische Darstellung unterschiedlicher Modifikationskonzentrationen;
- Fig. 9a-9c: drei schematische Querschnittsdarstellungen, die jeweils Modifikationsblöcke in einem Festkörper zeigen;
- Fig. 9d-9e: zwei schematische Darstellungen jeweils entlang der Ablösebereiche geteilter Festkörper, wobei die Darstellung gemäß Fig. 9d keine Modifikationsreste zeigt und die Darstellung gemäß der Fig. 9e Modifikationsreste zeigt;
- Fig. 10a-c: drei schematische Darstellung von Modifikationsblöcken und den dadurch erzeugten lokalen Festkörperschwächungen oder lokalen Festkörperanrissen;
- Fig. 11a-c: drei schematische Darstellung von exemplarischen Rissverläufen;
- Fig. 12a-c: das mehrfache Abtrennen von Festkörperanteilen bzw. Festkörperschichten, insbesondere Wafern, von einem Festkörper;
- Fig. 13a-d: mehrere Schritte von der Bereitstellung des Festkörpers bis zur Rissauslösung;
- Fig. 14a: eine schematische Darstellung des Zustands nach der Festkörperanteilabtrennung;
- Fig. 14b: eine weitere Laserbeaufschlagung des Restfestkörpers zum Erzeugen von Modifikationen zum Abtrennen einer weiteren Festkörperschicht;
- Fig. 14c: eine schematische Darstellung des Restfestkörpers angeordnet an einer Kühleinrichtung, wobei die Kühleinrichtung an einer Verfahreinrichtung, insbesondere einem Rotationstisch, angeordnet ist;
- Fig. 14d: eine schematische Darstellung der Erzeugung von Modifikationen im Festkörper;
- Fig. 15: eine schematische Darstellung einer Kühleinrichtung, insbesondere eines Kühlchucks;
- Fig. 16: eine schematische Darstellung einer bevorzugt eingesetzten Optik; und
- Fig. 17: eine schematische Darstellung überlagernder Strahlen bzw. Strahlenanteile bei der Erzeugung einer Modifikation im Festkörper.

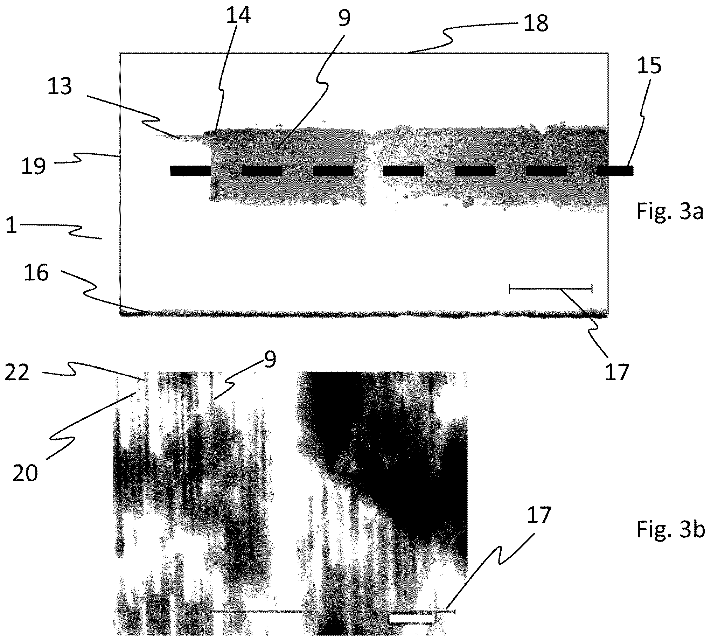

Das Bezugszeichen 1 kennzeichnet hierbei den Festkörper. In dem Festkörper 1 werden erfindungsgemäß Modifikationen 9 erzeugt, um einen Ablösebereich 2 auszubilden, an dem bzw. entlang dem der Festkörper 1 in mindestens zwei Bestandteile getrennt wird. Die Modifikationen 9 bewirken dabei unterkritische Risse, durch welche der Ablösebereich 2 geschaffen wird. Die Modifikationen 9 werden durch mindestens einen Laserstrahl 4 erzeugt. Der Laserstrahl 4 dringt über eine bevorzugt behandelte, insbesondere polierte, Oberfläche 5 in den bevorzugt zumindest teilweise transparenten Festkörper 1 ein. An der Oberfläche 5 wird der mindesten eine Laserstrahl bevorzugt gebrochen, was durch das Bezugszeichen 6 gekennzeichnet ist. Der mindestens eine Laserstrahl bildet dann einen Fokus 8 zur Erzeugung der Modifikation aus. Die polierte Oberfläche 5 kann auch als Hauptoberfläche 18 bezeichnet werden (vgl. Fig. 3a).

Das Bezugszeichen 10 kennzeichnet einen ersten Festkörperanteil nach dem Durchtrennen des Festkörpers 1 und das Bezugszeichen 12 kennzeichnet den zweiten Festkörperanteil nach dem Durchtrennen des Festkörpers 1. Das Bezugszeichen 11 kennzeichnet ferner die Oberflächen, entlang der die zwei Festkörperanteile 10, 12 voneinander getrennt wurden. Es ist ersichtlich, dass die Modifikationen 9 im Wesentlichen, mehrheitlich oder vollständig in dem Festkörperanteil 10 vorhanden sind und der Festkörperanteil 12 nach dem Abtrennen bevorzugt keine oder nur sehr wenige Modifikationen aufweist, insbesondere weniger als 30 Prozent der erzeugten Modifikationen aufweist. Es ist hierbei jedoch ebenfalls denkbar, dass die Modifikationen mehrheitlich in dem zweiten Festkörperanteil 12 verbleiben.

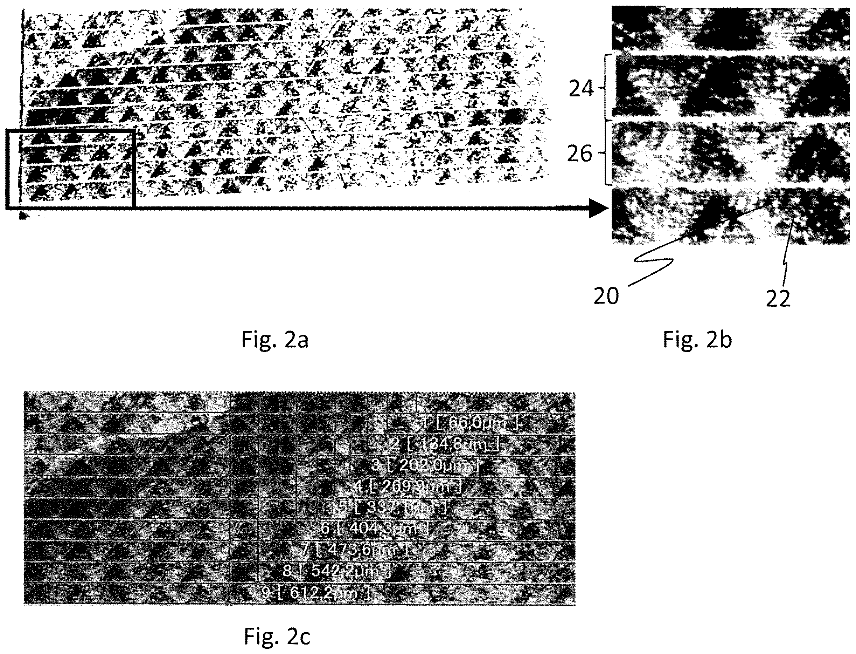

Fig. 2a bis 2c zeigen unterschiedliche mikroskopische Darstellungen eines mittels Laser konditionierten bzw. modifizierten Festkörpers 1, insbesondere mehrheitlich oder im Wesentlichen oder vollständig bestehend aus z.B. einem Halbleitermaterial, insbesondere aus SiC.

In Fig. 2a ist ein 6H-SiC-Liniendefekte-Feld 1E gezeigt, das mit Pulsabständen von 0,4 µm, Linienabständen von linenmäßig erzeugten Kristallgittermodifikationen 20, 22 von 2 µm und einer Pulswiederholfrequenz von 128 kHz erzeugt wurde. Es ist hierbei jedoch ebenfalls denkbar, dass einer der Parameter, mehrere dieser Parameter, insbesondere zwei dieser Parameter, oder alle dieser Parameter (Pulsabstände, Linenabstände, Pulswiederholfrequenz) variiert oder verändert festgelegt werden. So können die Pulsabstände z.B. zwischen 0,01 µm und 10 µm vorgesehen werden und/oder die Linienabstände zwischen 0,01 µm und 20 µm vorgesehen werden und/oder die Pulswiederholfrequenz zwischen 16kHz und 1024kHz vorgesehen werden.

In Fig. 2b ist eine vergrößerte Detaildarstellung des durch den Rahmen in Fig. 2a gekennzeichneten Bereichs dargestellt. Es ist erkennbar, dass die Blockabstände 24, 26 bevorzugt gleichmäßig ausgebildet sind und z.B. 66 µm betragen. Fig. 2c zeugt ebenfalls Blockabstände, die bei ca. 66 µm liegen. Es ist jedoch ebenfalls denkbar, dass die Blockabstände in anderen Bereichen liegen, wie z.B. im Bereich zwischen 4 µm und 1000 µm.

Die Darstellung der Fig. 2a stellt eine Draufsicht auf einen Festkörper durch eine polierte Oberfläche des Festkörpers dar. Die gezeigte Struktur ist somit innerhalb des Festkörpers ausgebildet bzw. durch die Modifikation, insbesondere mittels Laser, erzeugt worden.

Eine Rissbildung setzt in der dargestellten Konfiguration bevorzugt nicht ein.

Die Figuren 3a und 3b zeigen mikroskopische Darstellungen von im Sinne der Erfindung modifizierten Festkörpern. In Fig. 3a kennzeichnet das Bezugszeichen 14 bevorzugt den Ort eines Bearbeitungsstarts, d.h. der Ort an dem bevorzugt die Modifikation des Kristallgitters des Festkörpers 1 begonnen wird. Das Bezugszeichen 9 kennzeichnet den modifizierten Bereich in dem Festkörper 1. Es ist aus dieser Darstellung ersichtlich, dass sich außermittig des modifizierten Bereichs 9 bzw. versetzt zum Zentrum 15 des modifizierten Bereichs 9 ein Riss 13 in dem Festkörper 1 ausbreitet. Es ist hierbei möglich, dass der Ort und die Richtung der Ausbreitung des Risses 13 durch definierte Parameter zur Erzeugung der Modifikation definiert vorgegeben werden, wobei der Riss 13 im gezeigten Beispiel bevorzugt parallel oder im Wesentlichen parallel zur Hauptoberfläche 18 verläuft. Der Riss 13 kann somit durch Parametereinstellung/en gezielt durch die Modifikationen 9 hindurch, am Rand der Modifikationen 9 oder beabstandet zu den Modifikationen 9 erzeugt bzw. ausgelöst und geführt werden.

Die Unterseite des Festkörpers 1, insbesondere des Wafers, wird durch das Bezugszeichen 16 angegeben. Ferner weist das Bezugszeichen 17 auf eine Referenzlänge hin, die bevorzugt 50 µm misst. Die gezeigte Querschnittsfläche erstreckt sich rechtwinklig zur Hauptoberfläche 18 des Festkörpers 1, d.h. über die Höhe der seitlichen Oberfläche 19, wobei bevorzugt über die Hauptoberfläche 18 die Modifikationen 9 in den Festkörper 1 eingebracht werden bzw. eine Erzeugung der Modifikationen 9 bevorzugt durch die Hauptoberfläche 18 hindurch bewirkt wird. Die Hauptoberfläche 18 ist besonders bevorzugt um ein Vielfaches, insbesondere mindestens doppelt oder mindestens dreifach oder mindestens vierfach oder mindestens 10 fach oder mindestens 20 fach oder mindestens 50-fach, größer als die seitliche Oberfläche 19.

Fig. 3a zeigt bevorzugt ein 6H-SiC-Liniendefekte-Feld 1C, das mit Pulsabständen von 0,2 µm, Linienabständen von linienmäßig erzeugten Kristallgittermodifikationen 20, 22 von 3 µm und einer Pulswiederholfrequenz von 128 kHz erzeugt wurde. Es ist hierbei jedoch ebenfalls denkbar, dass einer der Parameter, mehrere dieser Parameter, insbesondere zwei dieser Parameter, oder alle dieser Parameter (Pulsabstände, Linienabstände, Pulswiederholfrequenz) variiert oder verändert festgelegt werden. So können die Pulsabstände z.B. zwischen 0,01 µm und 10 µm vorgesehen werden und/oder die Linienabstände z.B. zwischen 0,01 µm und 20 µm vorgesehen werden und/oder die Pulswiederholfrequenz z.B. zwischen 16kHz und 1024kHz vorgesehen werden.

Fig. 3b zeigt eine Draufsicht auf einen Teil des Festkörpers 1 und durch die polierte Hauptoberfläche 18 hindurch auf die Modifikationen 9. Die einzelnen Modifikationen 9 sind gemäß dieser Darstellung derart erzeugt, dass mehrere von ihnen eine Linie 20, 22 bilden. Es ist hierbei jedoch ebenfalls denkbar, dass die Modifikationen zumindest teilweise in mehr als einer Richtung, insbesondere in zwei Richtungen, in mindestens zwei Richtungen oder in drei Richtungen homogen erzeugt werden. So werden die Modifikationen 9 besonders bevorzugt in einer zur Hauptoberfläche 18 parallelen ebene bevorzugt gleichmäßig bzw. homogen verteilt erzeugt. Es ist jedoch ebenfalls denkbar, dass in einer Richtung (Länge oder Breite oder Höhe) mehr Modifikationen 9 erzeugt werden als in einer oder zwei anderen Richtungen. Ferner ist denkbar, dass die Modifikationen 9 derart erzeugt werden, dass sie Muster darstellen. Weiterhin können die Modifikationen 9 im Sinne der vorliegenden Erfindung in verschiedenen Bereichen des Festkörpers 1, wobei die Bereiche bevorzugt dieselben Abmessungen aufweisen, in unterschiedlicher Anzahl und/oder mit unterschiedlichen Parametern erzeugt werden.

Das Bezugszeichen 17 kennzeichnet in Fig. 3b eine Referenzlänge, die bevorzugt 100 µm misst.

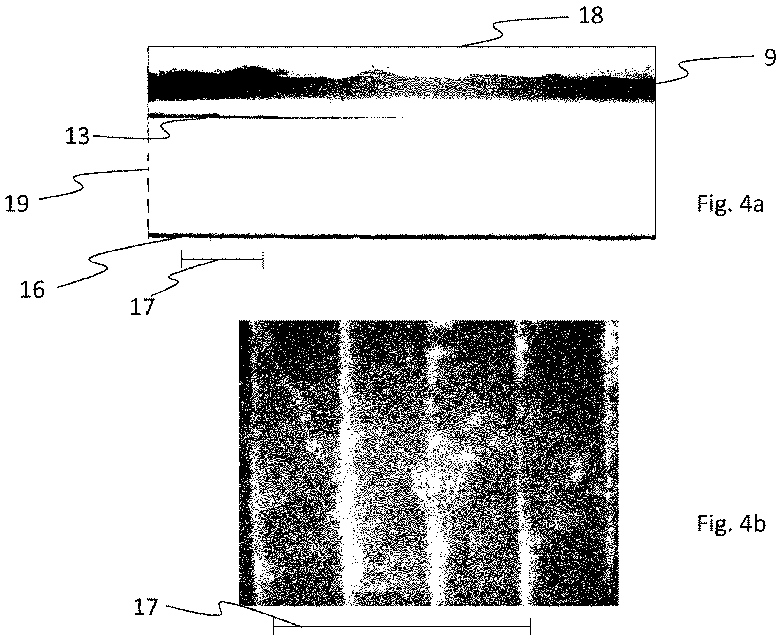

Fig. 4a zeigt bevorzugt ein 6H-SiC-Liniendefekte-Feld 1A, das mit Pulsabständen von 0,2 µm, Linienabständen von linienmäßig erzeugten Kristallgittermodifikationen 20, 22 von 1 µm und einer Pulswiederholfrequenz von 128 kHz erzeugt wurde. Es ist hierbei jedoch ebenfalls denkbar, dass einer der Parameter, mehrere dieser Parameter, insbesondere zwei dieser Parameter, oder alle dieser Parameter (Pulsabstände, Linienabstände, Pulswiederholfrequenz) variiert oder verändert festgelegt werden. So können die Pulsabstände z.B. zwischen 0,01 µm und 10 µm vorgesehen werden und/oder die Linienabstände z.B. zwischen 0,01 µm und 20 µm vorgesehen werden und/oder die Pulswiederholfrequenz z.B. zwischen 16kHz und 1024kHz vorgesehen werden.

Ferner kann Fig. 4a entnommen werden, dass sich beabstandet zu den erzeugten Modifikationen 9 ein Riss 13 in dem Festkörper 1 ausbreitet. Der Riss 13 breitet sich somit beabstandet zum Zentrum der Modifikationen 9 aus bzw. der Riss breitet sich in einem Bereich des Festkörpers 1 aus, der zu dem Hauptmodifikationsanteil beabstandet ist. Der Hauptmodifikationsanteil ist, z.B. bei durch LASER erzeugte Modifikationen 9, dabei bevorzugt der Anteil des Festkörpers 1, in dem der Laser seinen Fokus hat.

Das Bezugszeichen 17 kennzeichnet eine Referenzläng, die bevorzugt 100 µm beträgt.

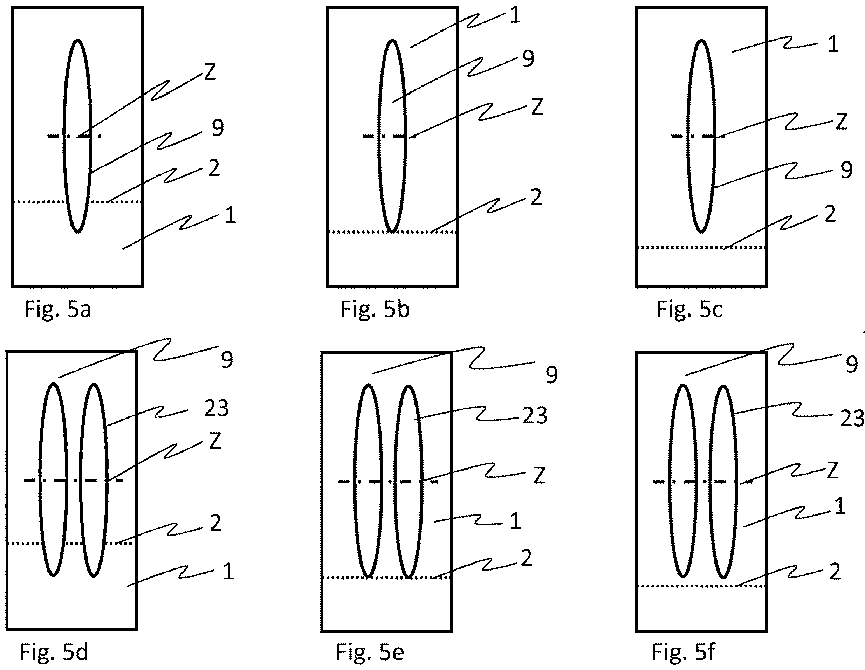

Die Figuren 5a bis 5f zeigen verschiedene Darstellungen des Modifikation-Risserzeugungs-Zusammenhangs. Fig. 5a zeigt beispielsweise eine z.B. entsprechend der Form einer Lasertaille geformte Modifikation 9. Es wird jedoch darauf hingewiesen, dass die Form der Modifikation 9 lediglich schematisch dargestellt ist. Ferner sind auch von der gezeigten Form abweichende Formen denkbar. So kann eine Modifikation 9 bevorzugt eine Form aufweisen, die im Gestaltungsraum zwischen einer sphärischen Form, insbesondere einem Kreis, und einem Vieleck, insbesondere einem Viereck, insbesondere einem Rechteck, wie z.B. einem Quadrat, liegt. Weiterhin zeigt die Fig. 5a, dass sich der Ablösebereich 2 nicht durch das Zentrum Z der Modifikation 9 erstreckt. Bevorzugt ist der Ablösebereich 2 um 1/20 oder 1/10 oder 1/5 oder 1/4 oder 1/3 oder die Hälfte der maximalen Länge der Modifikation 9 von dem Zentrum der Modifikation beabstandet.

Fig. 5b zeigt z.B. eine Variante, gemäß welcher der Ablösebereich 2 am äußeren Rand bzw. im Bereich des äußeren Randes der Modifikation 9 an der Modifikation 9 vorbeiläuft und die Modifikation daher besonders bevorzugt lediglich außen passiert jedoch nicht durch die Modifikation hindurch läuft.

Fig. 5c zeigt eine weitere Variante, gemäß welcher der Ablösebereich 2 bevorzugt um zumindest 0,01 µm oder um mindestens 0,1 µm oder um mindestens 1 µm oder um mindestens 5 µm oder um mindestens 10 µm von der Modifikation 9 beabstandet ist.

Die Figuren 5d bis 5f sind analog zu den Figuren 5a bis 5c aufgebaut. Die Figuren 5d bis 5e zeigen jedoch eine Variante, gemäß welcher der durch die Modifikation 9 erzielte Effekt, nämlich das lokale Durchtrennen des Kristallgitters des Festkörpers 1, erst durch das Zusammenwirken mehrerer Modifikationen 9, insbesondere von mindestens 2, 5, 10, 20, 50 oder von mindestens 100 Modifikationen, entsteht.

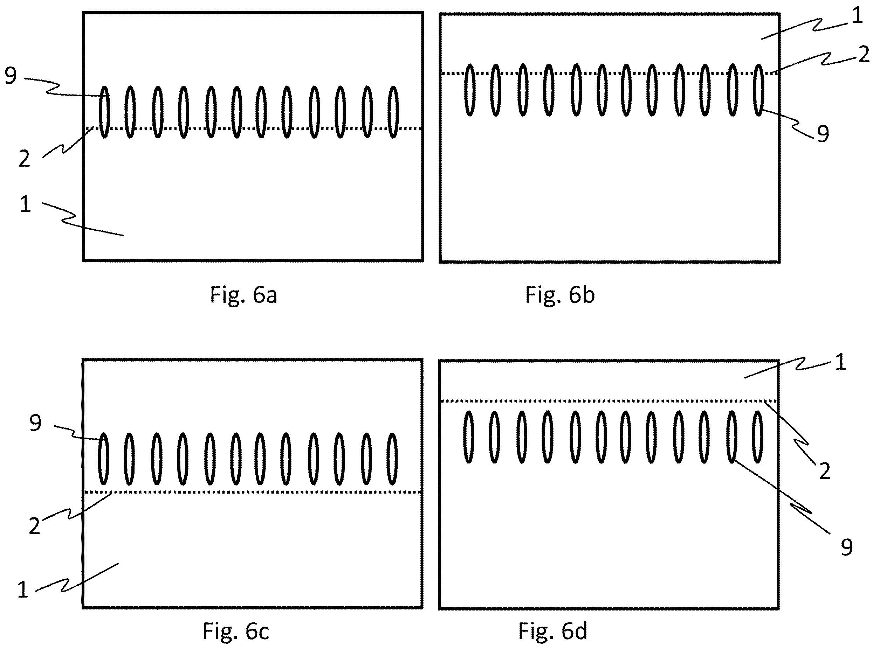

Die Figuren 6a bis 6d zeigen verschiedene Anordnungen von Modifikationen 9 und den aufgrund der Modifikation 9 sich ergebender Ablösebereiche 2. Je nach Bedarf können daher die zur Erzeugung der Modifikation erforderlichen Parameter derart eingestellt werden, dass der Ablösebereich 2 durch die Modifikationen 9 hindurch läuft (vgl. Fig. 6a und 6b) oder dass der Ablösebereich zu den Modifikationen 9 beabstandet ist. (vgl. Fig. 6c-6d).

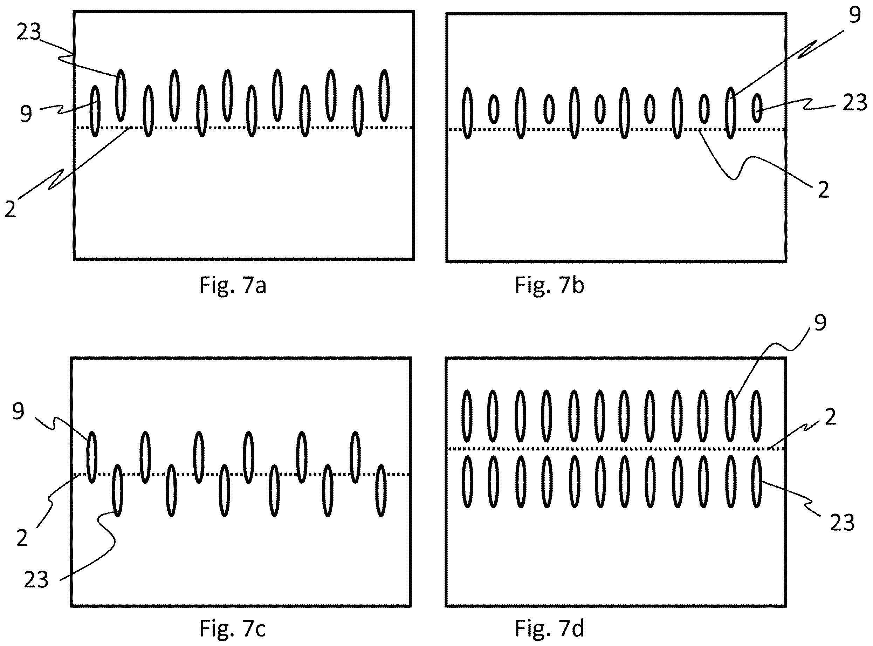

Die Figuren 7a-7d zeigen weitere Varianten, gemäß denen sich infolge der Erzeugung von Modifikationen 9 in einem Festkörper 1 ein Ablösebereich 2 ausbildet. Gemäß den Figuren 7a und 7b können die Zentren der Modifikationen 9 und 23 auf einer Seite des Ablösebereichs 2 vorgesehen sein. Es ist hierbei jedoch denkbar, dass die Modifikationen bis auf den Ort ihrer Erzeugung (insbesondere der Abstand zur Hauptoberfläche) identisch erzeugt werden. Ferner ist denkbar, dass sich zusätzlich oder alternativ zu dem Ort der Modifikationen 9, 23 der Fokus und/oder die Energiemenge und/oder die Beaufschlagungszeit, etc. ändert. In den Figuren 7c bis 7d sind die Zentren der Modifikationen 9 und 23 jeweils auf verschiedenen Seiten des Ablösebereichs 2.

Es ist hierbei denkbar, dass die Zentren der Modifikationen 9, 23 im gleichen Abstand oder in verschiedenen Abständen zum Ablösebereich 2 ausgebildet werden. Ferner ist denkbar, dass sich zusätzlich oder alternativ zu dem Ort der Modifikationen 9, 23 der Fokus und/oder die Energiemenge und/oder die Beaufschlagungszeit, etc. ändert bzw. unterschiedlich eingestellt wird.

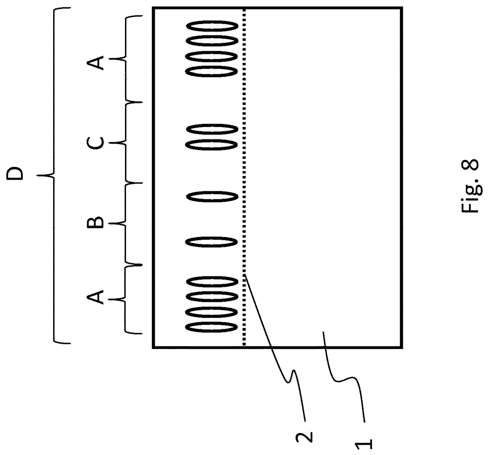

Fig. 8 zeigt eine Anordnung, gemäß der die Modifikationen 9 lokal in unterschiedlichen Konzentrationen (A-D) und/oder Verteilungen erzeugt werden. Es ist hierbei z.B. denkbar, dass zur Auslösung eines die einzelnen Risse verbindenden Hauptrisses lokal unterschiedliche Modifikationskonzentrationen oder Verteilungen vorgesehen werden. Bevorzugt werden im Bereich einer Hauptrissauslösestelle mehr Modifikationen erzeugt bzw. es wird eine höhere Modifikationendichte vorgesehen.

Es wird ferner darauf hingewiesen, dass die einzelnen in den Figuren 5a-5f, 6a-6d, 7a-7d, 8 gezeigten Varianten bevorzugt miteinander kombinierbar sind.

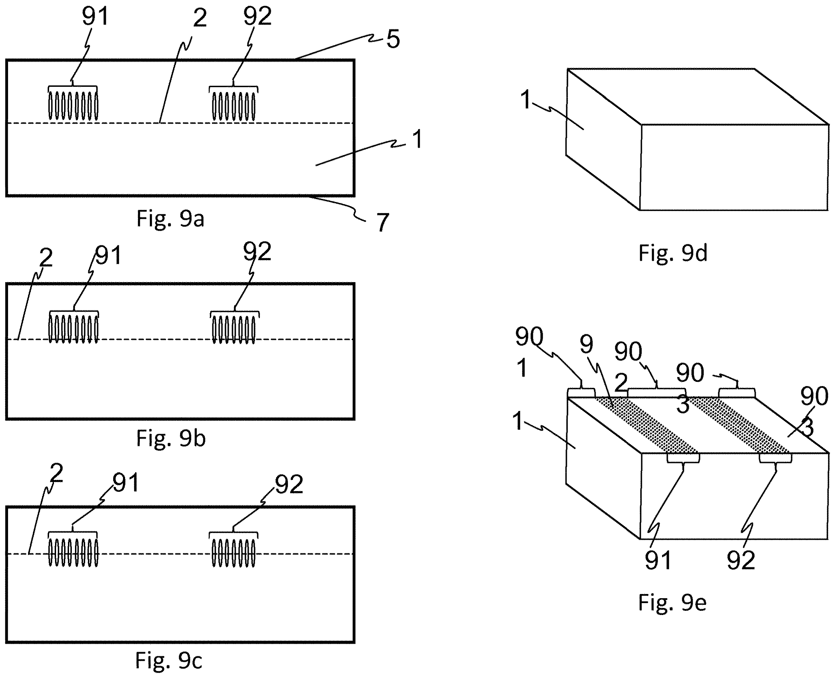

Fig. 9a zeigt, dass in zumindest zwei unterschiedlichen Bereichen des Festkörpers 1 die Anzahl der erzeugten Modifikationen je cm² verschieden ist. In einem ersten Bereich wird dabei ein erster Block 91 an Modifikationslinien erzeugt, wobei die einzelnen Modifikationen 9 je Linie bevorzugt weniger als 10 µm, insbesondere weniger als 5 µm oder weniger als 3 µm oder weniger als 1 µm oder weniger als 0,5 µm, voneinander beabstandet erzeugt werden. Die einzelnen Linien des ersten Modifikationsblocks 91 werden bevorzugt weniger als 20 µm, insbesondere weniger als 15 µm oder weniger als 10 µm oder weniger als 5 µm oder weniger als 1 µm, voneinander beabstandet erzeugt. Durch den ersten Bock 91 an Modifikationen 91 werden mechanische Spannungen in dem Festkörper 1 erzeugt.

In einem zweiten Bereich wird ein zweiter Block 92 an Modifikationslinien erzeugt wird, wobei die einzelnen Modifikationen 9 je Linie bevorzugt weniger als 10 µm, insbesondere weniger als 5 µm oder weniger als 3 µm oder weniger als 1 µm oder weniger als 0,5 µm, voneinander beabstandet erzeugt werden. Die einzelnen Linien des zweiten Blocks 92 werden bevorzugt weniger als 20 µm, insbesondere weniger als 15 µm oder weniger als 10 µm oder weniger als 5 µm oder weniger als 1 µm, voneinander beabstandet erzeugt. Durch den zweiten Bock 92an Modifikationen 92 werden mechanische Spannungen in dem Festkörper 1 erzeugt.

Der erste Bereich und der zweite Bereich sind durch einen dritten Bereich voneinander beabstandet, wobei in dem dritten Bereich keine oder im Wesentlichen keine Modifikationen 9 mittels Laserstrahlen erzeugt werden und der erste Bereich zum zweiten Bereich um mehr als 20 µm, insbesondere mehr als 50 µm oder mehr als 100 µm oder mehr als 150 µm oder mehr als 200 µm, beabstandet ist.

Die Modifikationen 9 werden hierbei bevorzugt über eine Oberfläche 5 der späteren Festkörperschicht 12 in den Festkörper 1 eingebracht. Der Abstand zwischen der Oberfläche 5, über welche die Laserstrahlen eingebracht werden, zu den Modifikationen 9 ist bevorzugt geringer als der Abstand von den Modifikationen 9 zu einer zur Oberfläche 5 beabstandeten und bevorzugt parallel ausgerichteten weiteren Oberfläche 7 des Festkörpers 1.

Es ist ersichtlich, dass der Ablösebereich 2 gemäß dieser Darstellung einerseits, insbesondere in Festkörperlängsrichtung unterhalb oder oberhalb, aller Modifikationen 9 liegt und bevorzugt beabstandet zu den Modifikationen 9 ist.

Fig. 9b zeigt einen ähnlichen Grundaufbau. Gemäß Fig. 9b erstreckt sich der Ablösebereich 2 jedoch durch die Modifikationen 9 hindurch.

Ferner zeigt Fig. 9c, dass der Ablösebereich 2 auch durch das Zentrum der Modifikationen 9 laufen kann.

Der Verlauf des Ablösebereichs 2 ist hierbei z.B. über die Anzahl der Modifikationen 9 und/oder die Größe der Modifikationen 9 und/oder den Abstand der einzelnen Modifikationen 9 eines Blocks 91, 92 einstellbar.

Fig. 9d zeigt den Restfestkörper 1 nach dem Abtrennen der Festkörperschicht 12 entlang dem in Fig. 9a gezeigten Ablösebereich 2. Da in diesem Fall die Modifikationen 9 vollständig von dem Restfestkörper 1 entfernt werden, zeigt der Restfestkörper 1 keine Reste dieser Modifikationen 9.

Der Fig. 9e hingegen lassen sich Reste der Modifikationen 9 entnehmen. Diese Modifikationsreste ergeben sich, wenn der Festkörper 1 entlang einem der in den Figuren 9b oder 9c gezeigten Ablösebereiche 2 abgetrennt wird. Ferner kann erkannt werden, dass die Modifikationsblöcke 91, 92 bevorzugt durch Felder 901, 902, 903 ohne Modifikationen bzw. mit weniger Modifikationen je cm2 voneinander beabstandet werden. Die Felder ohne Modifikationen 9 oder mit weniger Modifikationen 9 können hierbei bevorzugt kleiner oder größer sein als die Bereich, in denen die Modifikationsblöcke 91, 92 erzeugt werden. Bevorzugt sind zumindest einzelne, mehrere oder die Mehrzahl der Bereiche, in denen die Modifikationsblöcke 91 92 erzeugt werden, um ein Vielfaches, insbesondere um mindestens das 1,1 fache oder das 1,5 fache oder das 1,8 fache oder das 2 fache oder das 2,5 fache oder das 3 fache oder das 4 fache, größer als die Bereiche, in denen keine Modifikationen 9 oder weniger Modifikationen 9 erzeugt werden.

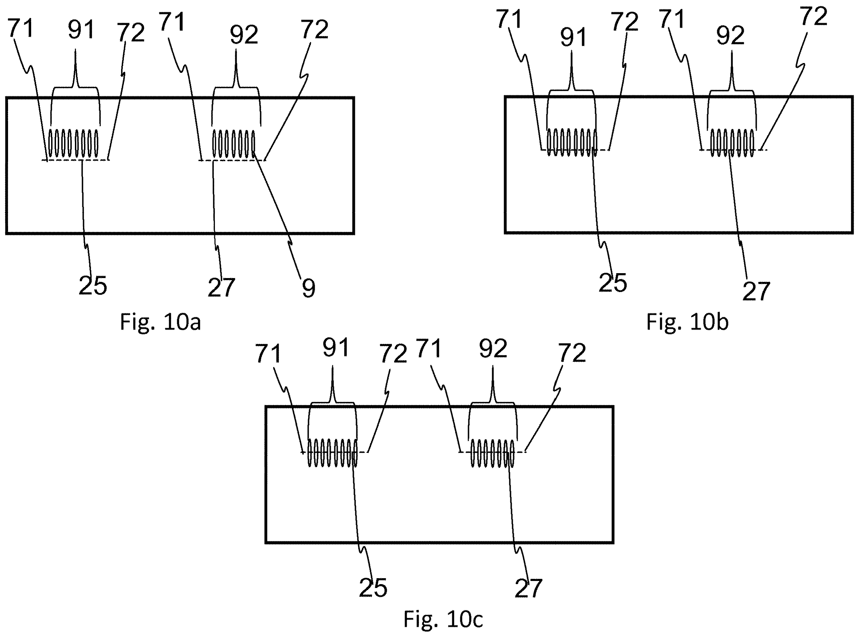

Die Figuren 10a-10c zeigen eine weitere Ausführungsform der vorliegenden Erfindung. Gemäß dieser Darstellungen dienen die Modifikationsblöcke 91, 92 zum Erzeugen von lokalen Materialschwächungen oder lokalen Festkörpereinrissen oder lokalen Spannungserhöhungen. Das Bezugszeichen 25 kennzeichnet hierbei einen ersten Teilablösebereich oder Rissanteil, in dem die lokalen Materialschwächungen oder lokalen Festkörpereinrissen oder lokalen Spannungserhöhungen auftreten, und das Bezugszeichen 27 kennzeichnet hierbei einen zweiten Teilablösebereich oder Rissanteil, in dem die lokalen Materialschwächungen oder lokalen Festkörpereinrissen oder lokalen Spannungserhöhungen ebenfalls auftreten. Die einzelnen Teilablösebereiche oder Rissanteile bilden bevorzugt Enden 71, 72 aus, über die der jeweilige Teilablösebereich oder Rissanteil hinaus vergrößert werden kann.

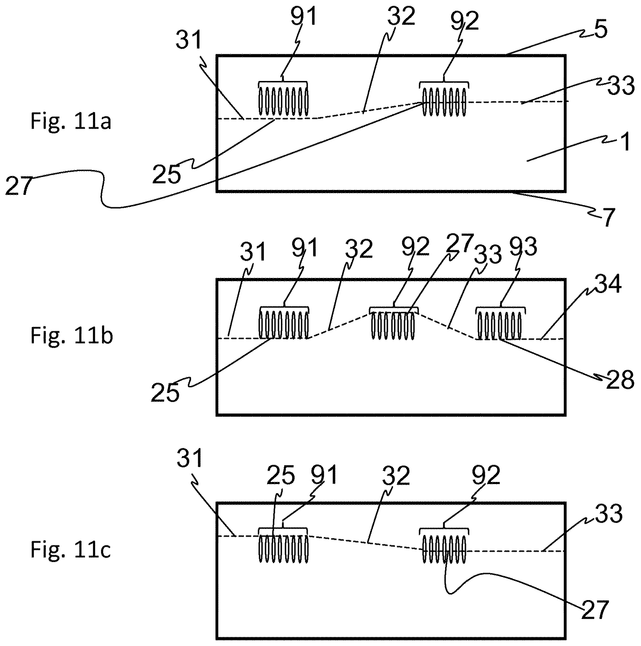

Die Figuren 11a bis 11c zeigen Ausführungsformen, gemäß denen der Verlauf des Ablösebereichs 2 infolge der Erzeugung der Modifikationsblöcke 91, 92, 93 derart gesteuert wird, dass vorbestimmte Muster oder Dickenveränderungen erzeugt oder kompensiert werden. Der Verlauf des Ablösebereichs 2 ist hierbei z.B. über die Anzahl der Modifikationen 9 und/oder die Größe der Modifikationen und/oder den Abstand der einzelnen Modifikationen 9 eines Blocks 91, 92, 93 einstellbar.

In Fig. 11a ist der Ablösebereich 2 durch die nachfolgend genannten Bestandteile gebildet: Riss 31 zwischen Außenkante und erstem Modifikationsblock 91, woran sich der erste Rissanteil 25, der unmittelbar durch den ersten Block 91 an Modifikationen 9 erzeugt wird, anschließt, woran sich Riss 32 zwischen den zwei Modifikationsblöcken 91 und 92 anschließt, woran sich der zweite Rissanteil 27 anschließt, der unmittelbar durch den zweiten Block 92 an Modifikationen 9 erzeugt wird, woran sich der Riss 33 zwischen dem Modifikationsblock 92 und der weiteren Außenkante des Festkörpers 1 anschließt. Es wird hierdurch ersichtlich, dass der Ablösebereich 2 derart vorgegeben werden kann, dass ein Riss zum Abtrennen der Festkörperschicht 12 von dem Festkörper 1, abschnittsweise auf verschiedenen Ebenen laufen kann.

Gemäß Fig. 11b ist ersichtlich, dass der Ablösebereich 2 derart gewählt werden kann, dass der Rissverlauf mehrere geometrische Wendepunkte enthält.

Fig. 11c zeigt rein exemplarisch eine weitere mögliche Ausgestaltung des Ablösebereichs 2.

Hinsichtlich der Figuren 11a-11c, ist festzuhalten, dass die Ausbildung von welligen Verläufen Vorteile bei der weiteren Behandlung der freigelegten Oberflächen, insbesondere bei nachgelagerten Schleif und/oder Polierschritten, bieten kann. Aufgrund der tatsächlich sehr geringen Höhe der Modifikationen 9 ist die tatsächliche Welligkeit, die hierrüber erzeugt wird nur sehr hochaufgelöst erfassbar. Mittels Modifikationsblöcken, wie z.B. den Blöcken 91, 92, 93, lässt sich der Riss jedoch sehr gut kontrolliert führen auch in den Bereichen, in denen keine oder weniger Modifikationen 9 erzeugt werden.

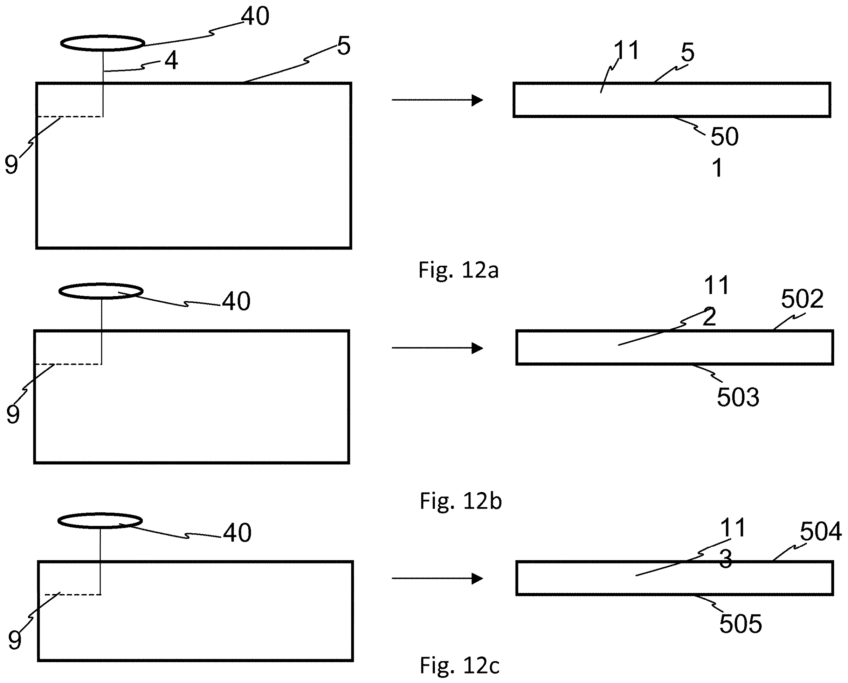

Die Figuren 12a-12c zeigen eine mehrfache Bearbeitung eines Festkörpers 1, insbesondere eines Ingots, wobei der Festkörper 1 jeweils um einen Festkörperanteil 12, insbesondere eine Festkörperschicht 12, gedünnt wird.

Die Figuren 12a-12c zeigen somit jeweils das Beaufschlagen des Festkörpers 1 mit LASER-Strahlung der LASER-Lichtquelle, wobei die Laserstrahlen über eine Oberfläche 5, 502, 504 der abzutrennenden Festkörperschicht 12 in den Festkörper 1 eindringen. Durch die LASER-Strahlung wird ein vorgegebener Anteil des Festkörpers 1 im Inneren des Festkörpers 1 zur Ausbildung eines Ablösebereichs 2 oder mehrerer Teilablösebereiche definiert temperiert, die in dem vorgegebenen Anteil des Festkörpers 1 erzeugte Temperatur ist dabei bevorzugt so hoch, dass das den vorgegebenen Anteil ausbildende Material Modifikation 9 in Form einer vorbestimmten Stoffumwandlung erfährt. Die Anzahl und Anordnung der Modifikationen 9 ist dabei einstellbar und wird bevorzugt vorgegeben. Nach der Abtrennung des Festkörperanteils 12 wird eine erneute Beaufschlagung des Restfestkörpers 1 mit LASER-Strahlung der LASER-Lichtquelle durchgeführt, wobei die LASER-Strahlung einen vorgegebenen Anteil des Restfestkörpers 1 im Inneren des Restfestkörpers 1 zur Ausbildung eines Ablösebereichs 2 definiert temperiert, und die in dem vorgegebenen Anteil des Restfestkörpers 1 erzeugte Temperatur wiederum so hoch ist, dass das den vorgegebenen Anteil ausbildende Material eine vorbestimmte Stoffumwandlung erfährt. Somit können z.B. gleich, ähnlich oder verschieden dicke Festkörperanteile 12, insbesondere Festkörperschichten 12, insbesondere Wafer, von einem Festkörper 1 abgetrennt werden. Bevorzugt weist der Festkörper 1 eine solche Länge auf, dass eine Vielzahl, insbesondere mehr als 2 oder mehr als 5 oder mehr als 10 oder mehr als 20 oder mehr als 50 oder mehr als 100 oder mehr als 150 oder mehr als 200 Festkörperschichten 12 mit einer Dicke von weniger als 1000 µm, insbesondere von weniger als 800 µm oder von weniger als 500 µm oder von weniger als 300 µm oder von weniger als 200 µm oder von weniger als 150 µm oder von weniger als 110 µm oder von weniger als 75 µm oder von weniger als 50 µm, davon abtrennbar sind. Bevorzugt erfolgt nach jedem Abtrennen einer Festkörperschicht 12 eine spanende Bearbeitung der neu freigelegten Oberfläche 502, 504 des Restfestkörpers 1.

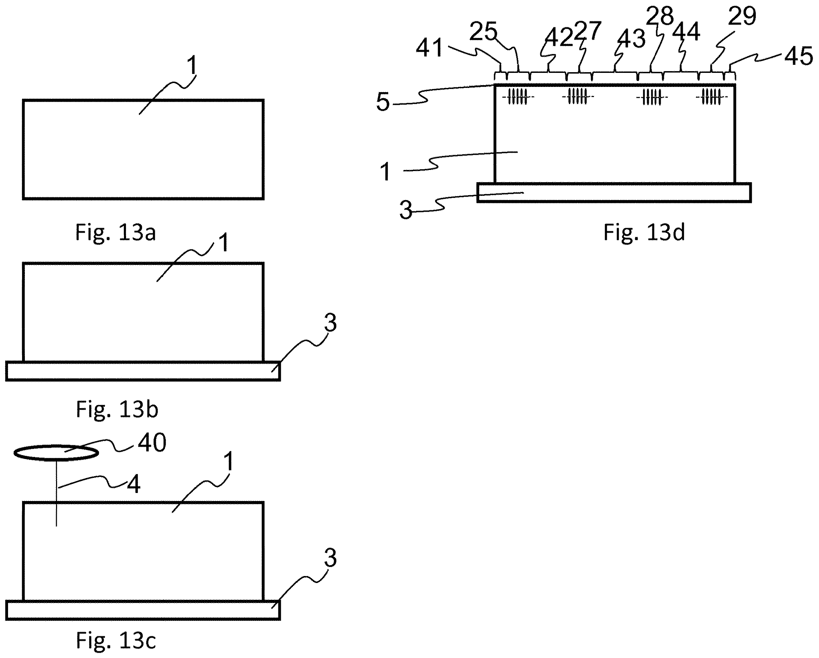

Die Figuren 13a-13f zeigen schematische Darstellungen unterschiedliche Prozesssituationen, wie sie gemäß dem erfindungsgemäßen Verfahren zum Herstellen von Festkörperschichten 12 auftreten können.

Fig. 13a zeigt die Bereitstellung des Festkörpers 1, insbesondere eines Ingots.

Gemäß Fig. 13b ist der bereitgestellte Festkörper 1 an einer Kühleinrichtung 3 angeordnet. Bevorzugt ist die Kühleinrichtung 3 ein Kühlchuck. Besonders bevorzugt wird der Festkörper 1 an einem Werkzeugträger (Chuck) angekoppelt bzw. angeklebt oder angeschweißt oder angeschraubt oder angeklemmt, wobei der Werkzeugträger bevorzugt eine Kühlfunktionalität umfasst und dadurch bevorzugt zur Kühleinrichtung 3 wird. Der Werkzeugträger besteht bevorzugt aus einer Legierung mit einer Zusammensetzung von 45%-60%, insbesondere 54%, Eisen, 20%-40%, insbesondere 29% Nickel und 10%-30%, insbesondere 17% Cobald. Die Prozentangaben beziehen sich hierbei auf den Anteil an der Gesamtmasse. Ein Beispiel für eine bevorzugte Kühleinrichtung 3 ist in Fig. 11 gezeigt. Der Festkörper 1 und die Kühleinrichtung 3 weisen bevorzugt die gleiche bzw. eine ähnliche Wärmeausdehnung auf. Als ähnliche Wärmeausdehnung wird hierbei bevorzugt jede Wärmeausdehnung bei einer Temperaturzunahme von 10°C in einem Temperaturbereich von -200°C bis 200°C verstanden, bei der die Differenz der Wärmeausdehnungen des Festkörpers 1 und der Kühleinrichtung 3 weniger als 50%, insbesondere weniger als 25% oder weniger als 10%, der Wärmeausdehnung des sich am stärksten ausdehnenden Objekts (Kühleinrichtung oder Ingot) beträgt. Die Wärmeausdehnung des Festkörpers 1 beträgt bevorzugt weniger als 10ppm/K, insbesondere weniger als 8ppm/K oder weniger als 5ppm/K, wie z.B. weniger als 4ppm/K oder im Wesentlichen 4ppm/K oder genau 4ppm/K.

Der Festkörper 1 wird bevorzugt in Längsrichtung mit seiner Unterseite 7, die bevorzugt in Längsrichtung gegenüber der Oberfläche 5 liegt, an der Kühleinrichtung 3 fixiert, insbesondere angeklebt. Die Laserstrahlen werden somit zum Erzeugen der Modifikationen 9 über die Oberfläche 5, die Bestandteil der abzutrennenden Festkörperschicht 12 ist, in Richtung der Kühleinrichtung 3 in den Festkörper 1 eingeleitet.

Fig. 13c zeigt schematisch die Erzeugung der Modifikationen 9 mittels der Laserstrahlen. Die Kühleinrichtung 3 bewirkt hierbei, dass die durch die Laserstrahlen in den Festkörper 1 eingebrachte Energie bzw. Wärme zumindest teilweise und bevorzugt mehrheitlich aus dem Festkörper 1 ausgeleitet wird.

Fig. 13d zeigt eine schematische Schnittdarstellung des Festkörper 1 während der Erzeugung der Modifikationen 9. Gemäß diesem Beispiel sind 4 Blöcke an Modifikationen 9 erkennbar, die zu den 4 Rissanteilen 25, 27, 28, 29 führen. Angrenzend an die Blöcke mit Modifikationen 9 kennzeichnen die Bezugszeichen 41, 42, 43, 44 und 45 jeweils Bereiche ohne Modifikationen 9 oder Bereiche, in denen weniger Modifikationen 9 erzeugt sind, als in den Bereichen, in denen die Blöcke an Modifikationen 9 erzeugt sind. Der Gesamtriss bildet sich dabei besonders bevorzugt selbsttätig infolge des durch die Erzeugung der Teilrisse erzeugten Spannungen.

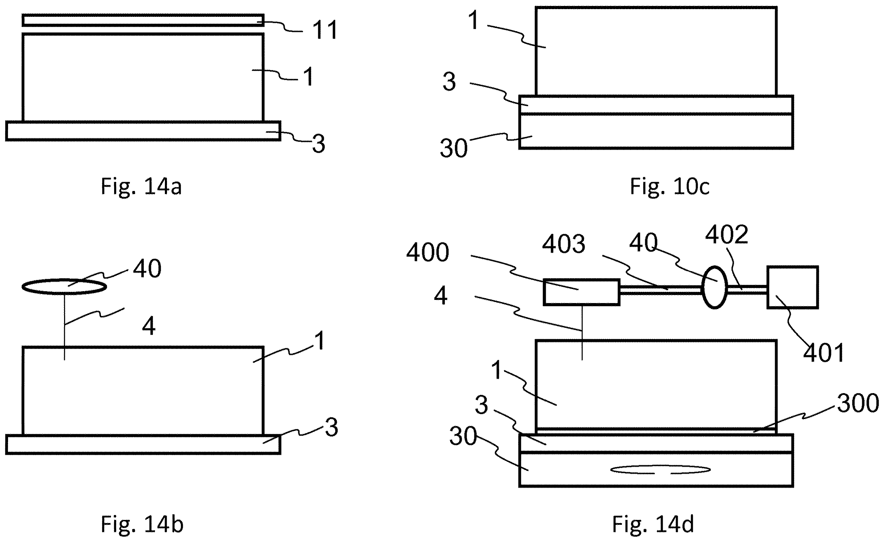

Fig. 14a zeigt eine Darstellung nach der in Fig. 13c gezeigten Laserbeaufschlagung.

Fig. 14b zeigt einen erneuten Schritt der Einbringung von Modifikationen 9 in den Restfestkörper 1, der zumindest um die bereits abgetrennte Festkörperschicht 12 in seiner Länge reduziert ist.

Fig. 14c zeigt schematisch eine weitere bevorzugte Ausgestaltung. Die Kühleinrichtung 3 ist hierbei einerseits mit dem Festkörper 1 gekoppelt und anderseits mit einer Verfahreinrichtung 30, insbesondere einer X-/Y-Verfahreinrichtung oder einem Rotationstisch, gekoppelt. Die Verfahreinrichtung 30 bewirkt eine Bewegung des Festkörpers 1, wodurch dieser gegenüber der Umgebung und einer Laseroptik, insbesondere einem Scanner, definiert bewegt werden kann.

Fig. 14d zeigt eine weiter detaillierte schematische Darstellung der Fig. 14c. Der runde Pfeil innerhalb der Verfahreinrichtung 30 kennzeichnet, dass diese rotierbar ist. Ferner ist zwischen dem Festkörper 1 und der Kühleinrichtung 3 eine Kopplungsschicht, insbesondere eine Klebeschicht, vorgesehen. Die Kopplungsschicht 30 ist hierbei bevorzugt derart ausgeführt, dass sie eine Vielzahl an Bearbeitungszyklen, insbesondere mehr als 200 oder mehr als 300 oder mehr als 500 Bearbeitungszyklen, bei hoher mechanischer und thermischer Belastung aushält. Ferner kann dieser Darstellung entnommen werden, dass die Laserstrahlenquelle 401 Laserstrahlen bevorzugt entlang eines ersten Laserstrahlenleiters 402 zu einer Optik 40 leitet, von wo aus die Laserstrahlen mittels eines weiteren Laserstrahlenleiters 403 zu einem Scanner gelangen. Es ist hierbei alternativ jedoch ebenfalls denkbar, dass zumindest die Laserstrahlenquelle 401 und der Scanner 400 vorgesehen sind.

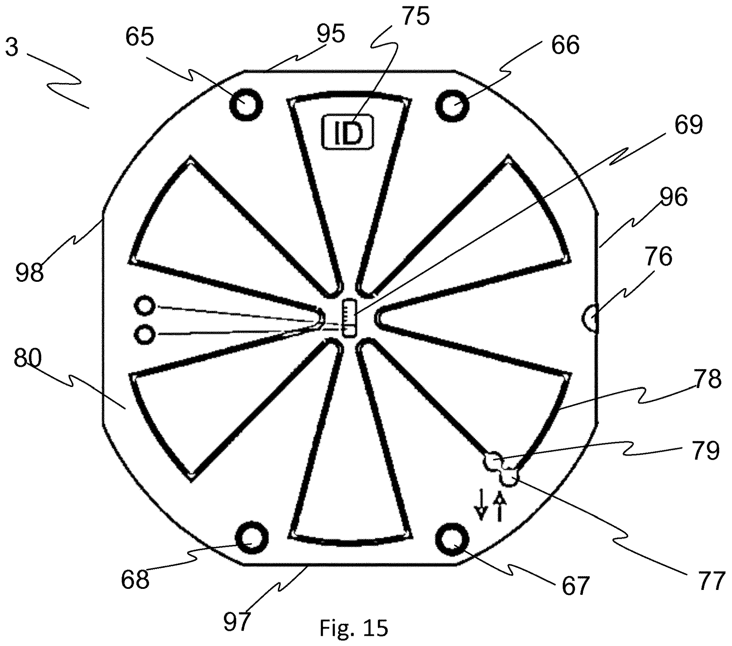

Fig. 15 zeigt die Kühleinrichtung 3. Die Kühleinrichtung 3 weist bevorzugt eine Leit-Stütz-Struktur auf, die bevorzugt durch einen Werkzeugträger, insbesondere ein Chuck, gebildet wird. Die Leit-Stütz-Struktur weist bevorzugt eine runde Grundform auf. Dies ist vorteilhaft, da hinsichtlich Spinnprozessen leichter eine Unwucht vermieden werden kann. Ferner ist die runde Grundform bevorzugt mit Abflachungen 95-98 versehen. Diese Abflachungen sind vorteilhaft, da sie eine Grobausrichtung und/oder Kassettierung erlauben bzw. erleichtern.

Bevorzugt weist die Kühleinrichtung 3, insbesondere die Leit-Stütz-Struktur der Kühleinrichtung 3, eine gute Wärmeleitfähigkeit auf. Ferner weist die Kühleinrichtung 3 bevorzugt eloxiertes Aluminium auf, wodurch Abriebpartikel reduziert bzw. verhindert werden. Dies ist vorteilhaft, da dadurch die Reinraumkompatibilität erhöht wird. Ferner ist der Chuck bevorzugt kompatibel zum Ablöseprozess.

Ferner sind bevorzugt mindestens zwei Ausrichtelemente 65-68 vorgesehen. Bevorzugt sind die Ausrichtelemente 65-68 als Ausrichtlöcher oder Schlitze oder Zapfen ausgebildet. Die Ausrichtelemente 65-68 bilden bevorzugt Mitnehmer für die kraftschlüssige und/oder formschlüssige Rotationsübertragung aus. Bevorzugt weisen die Ausrichtelemente 65-68 Stahl- oder Keramikeinsätze auf, wodurch eine hohe Verschleißfestigkeit erzielt wird. Die Ausrichtelemente 65-68 dienen bevorzugt zum Koppeln der Kühleinrichtung 3 mit der Verfahreinrichtung 30.

Ferner können Passstifte vorgesehen sein, diese können z.B. als Niederhalter ausgeführt sein, wodurch z.B. ein Kraft und/oder Formschluss mit der Leit-Stütz-Struktur erzeugbar ist.

Weiterhin ist bevorzugt eine Kerbe, Nut oder Markierung 76 an der Kühleinrichtung 3 vorgesehen. Dieses Merkmal ist vorteilhaft, da dadurch die Festkörperorientierung, insbesondere Ingotorientierung, ersichtlich ist. Die Kenntnis über die Orientierung des Festkörpers, insbesondere des Ingots, kann ausgenutzt werden, um die mittels der Laserstrahlen erzeugten Modifikationen 9 an die kristallographische Orientierung anpassen zu können.

Das Bezugszeichen 75 kennzeichnet rein exemplarisch ein optionales Datenträgerelement und/oder Datenübertragungselement und/oder Datenerfassungselement. Bevorzugt ist das durch das Bezugszeichen 75 gekennzeichnete Element als Barcode und/oder RFID-Element und/oder SAW Sensor ausgeführt. Dies lässt insbesondere eine Integration in ein Manufacturing Execution System (MES) zu.

Ferner sind auf oder in der Leit-Stütz-Struktur bevorzugt Kühlkanäle zum Leiten eines Kühlfluids vorgesehen bzw. ausgebildet. Der oder die Kühlkanäle 78 können zur Temperierung des Festkörpers 1, der Kühleinrichtung 3 und/oder einer Maschinenhalterung, insbesondere der Verfahreinrichtung 30, dienen. In den Kühlkanal 78 kann über einen Einlass 77 Kühlfluid, insbesondere eine Flüssigkeit, zugeführt werden und über einen Auslass 79 entfernt werden. Die Grenzfläche bzw. die Kopplungsschicht zwischen Festkörper 1 und Kühleinrichtung 3 weist bevorzugt eine hohe thermische Leitfähigkeit, insbesondere entsprechend der thermischen Leitfähigkeit des Festkörpers 1 oder der Kühleinrichtung 3 auf. Die Kühleinrichtung 3 kann zusätzlich oder alternativ über die Luftgrenzfläche gekühlt werden. Bei hohen Drehzahlen bzw. Verfahrgeschwindigkeiten der Verfahreinrichtung 30 ist die sich um die Kühleinrichtung 3 herum ausbildende Luftschicht sehr dünn, wodurch Wärme sehr gut ableitbar ist.

Weiterhin ist bevorzugt eine aktive Thermostatierung in das MES integriert. Zusätzlich oder alternativ erfolgt eine Prozessüberwachung für unterschiedliche Substratgrößen und - dicken.

Bevorzugt erfolgt eine Abdichtung der Fluidkanäle bei fixer Lagerung mittels Anpressen und bei Rotation mittels z.B. einer zentralen Ringdichtung.

Das Bezugszeichen 69 kennzeichnet eine optionale Sensoreinrichtung, die bevorzugt als Temperatursensor ausgeführt ist. Bevorzugt handelt es sich bei der Sensoreinrichtung um einen SAW Temperatursensor.

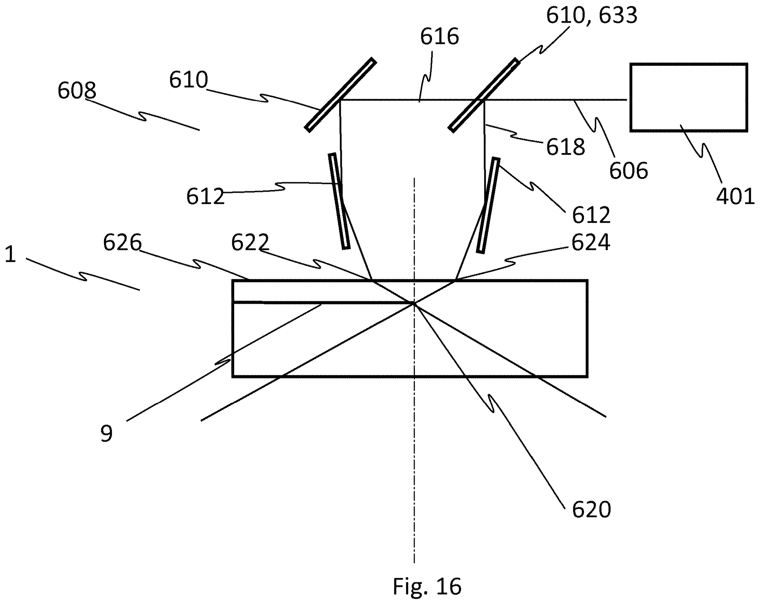

Fig. 16 zeigt die bevorzugt zur Erzeugung der Modifikationen 9 verwendete Optik 40, 608. Somit umfasst das erfindungsgemäße Verfahren bevorzugt ebenfalls den Schritt des Bereitstellens einer Optik 40, 608, wobei die Optik 608 bevorzugt mindestens zwei Umlenkelemente 610, 612 zum Umlenken von Lichtstrahlanteilen 616, 618 aufweist, Die Lichtstrahlen 616, 618 werden bevorzugt durch die Laserstrahlenquelle 401 erzeugt und emittiert. Ferner umfasst das erfindungsgemäße Verfahren bevorzugt den Schritt des Umlenkens zumindest zweier voneinander verschiedener Lichtstrahlanteile 616, 618 des emittierten Lichtstrahls 606 mittels der Umlenkelemente 610, 612, 613, wobei die Lichtstrahlanteile 616, 618 derart umgelenkt werden, dass sie in den Festkörper 1 eindringen und wobei die voneinander verschiedenen umgelenkten Lichtstrahlanteile 616, 618 in einem Fokus 620 innerhalb des Festkörpers 1 zusammentreffen und die physische Modifikation 9, insbesondere in Form eines Gitterdefekts, durch die im Fokus 620 zusammentreffenden Lichtstrahlenanteile 616, 618 erzeugt wird oder den Schritt des Erzeugens und Emittierens mindestens zweier Lichtstrahlen 606 durch die Laserstrahlenquelle bzw. Strahlungsquellenanordnung 401. Ferner umfasst das erfindungsgemäße Verfahren bevorzugt den Schritt des Umlenkens der Lichtstrahlen 606 mittels der Umlenkelemente 610, 612, 613, wobei die Lichtstrahlen 606 derart umgelenkt werden, dass sie in den Festkörper 1 eindringen und wobei die voneinander verschiedenen umgelenkten Lichtstrahlen 606 in einem Fokus 620 innerhalb des Festkörpers 1 zusammentreffen und die physische Modifikation 9, insbesondere in Form eines Gitterdefekts, durch die im Fokus 620 zusammentreffenden Lichtstrahlen 6 erzeugt wird.

Zusätzlich ist denkbar, dass zumindest zwei voneinander verschiedene Lichtstrahlanteile 616, 618 mindestens eines emittierten Lichtstrahls 606, insbesondere die Lichtstrahlenanteile mehrerer emittierter Lichtstrahlen, oder die mehreren emittierten Lichtstrahlen 606 mittels der Umlenkelemente 610, 612, 613 umgelenkt werden, wobei die Lichtstrahlanteile 616, 618 oder die Lichtstrahlen 606 derart umgelenkt werden, dass sie in den Festkörper 1 eindringen und wobei die voneinander verschiedenen umgelenkten Lichtstrahlanteile 616, 618 oder die voneinander verschiedenen umgelenkten Lichtstrahlen 606 in einem Fokus 620 innerhalb des Festkörpers 1 zusammentreffen und die physische Modifikation 9, insbesondere in Form eines Gitterdefekts, durch die im Fokus 620 zusammentreffenden Lichtstrahlenanteile 616, 618 oder Lichtstrahlen 606 erzeugt wird.

Weiterhin können gemäß dem erfindungsgemäßen Verfahren bei mehreren zeitgleich erzeugten Lichtstrahlen 606 mindestens zwei Lichtstrahlen 606 und bevorzugt alle Lichtstrahlen 606 in voneinander verschiedene, insbesondere unterschiedliche Wege zurücklegende, und an voneinander beabstandeten Oberflächenanteilen 622, 624 des Festkörpers 1 in den Festkörper 1 eindringende Lichtstrahlanteile 616, 618 aufgeteilt werden, wobei die Lichtstrahlanteile 616, 186 eines jeweiligen Lichtstrahls mittels voneinander verschiedener Umlenkelemente 610, 612, 613 umgelenkt werden.

Die Optik 608 weist bevorzugt mindestens ein Lichtstrahlaufspaltmittel 633, insbesondere einen Halbspiegel oder Strahlteiler, auf und mindestens ein Lichtstrahl 606 wird mittels mindestens dem Lichtstrahlaufspaltmittel 633 in mindestens zwei Lichtstrahlanteile 616, 618 aufgespalten. Bevorzugt wird ein Lichtstrahl 606 mittels einem Lichtstrahlaufspaltmittel 633, insbesondere einen Halbspiegel, in zumindest zwei Lichtstrahlanteile 616, 618 aufgespalten, wobei ein Lichtstrahlanteil 616 mittels mindestens zweier Umlenkelemente 610, 612, 613, insbesondere Spiegel, derart umgelenkt wird, dass er mit dem anderen Lichtstrahlanteil 618 im Inneren des Festkörpers 1 zum Bilden eines Fokus 620 zum Erzeugen der physischen Modifikation 9 zusammentrifft. Besonders bevorzugt wird eine Vielzahl physischer Modifikationen 9 erzeugt, wobei die physischen Modifikationen 9 bevorzugt eine Ebene und/oder eine Kontur und/oder eine Silhouette und/oder die äußere Gestalt eines Körpers bilden bzw. beschreiben.

Der mindestens eine von der Laserstrahlenquelle 401 emittierte Lichtstrahl 606 besteht bevorzugt aus kohärentem Licht und die Lichtwellen der im Fokus 620 zusammentreffenden Lichtstrahlanteile 616, 618 weisen bevorzugt die gleiche Phase und die gleiche Frequenz auf.

Besonders bevorzugt wird zumindest ein Lichtstrahlanteil 616, 618 oder zumindest ein Lichtstrahl 606 durch ein als Parabolspiegel ausgebildetes Umlenkelement 610, 612, 613 umgelenkt und fokussiert.

Ferner durchdringt der zumindest eine Lichtstrahlanteil 616, 618 oder der zumindest eine Lichtstrahl 606 vor der Umlenkung und Fokussierung bevorzugt ein Umlenkelement 610, 612, 613, insbesondere den Parabolspiegel, eine Strahlformungseinrichtung, insbesondere ein 1D-Teleskop, zum Verändern der Fokusform.

Durch die Laserstrahlenquelle 401 werden bevorzugt mindestens oder genau zwei Lichtstrahlen erzeugt, wobei die Lichtstrahlen 606 derart in Abhängigkeit von der Bandlücke des Materials des Festkörpers 1 mit voneinander verschiedenen Farben erzeugt werden, dass die Modifikation 9 durch einen Zwei-Photonen-Prozess erzeugt wird.

Bevorzugt wird durch einen ersten Lichtstrahl 606 ein erstes Laserfeld ausgebildet, wobei der erste Lichtstrahl 606 Photonen mit einer ersten Energie aufweist, und durch einen zweiten Lichtstrahl 606 wird bevorzugt ein zweites Laserfeld ausgebildet, wobei der zweite Laserstrahl 606 Photonen mit einer zweiten Energie aufweist, wobei das erste Laserfeld schwächer als das zweite Laserfeld ist und die erste Energie größer ist als die zweite Energie.

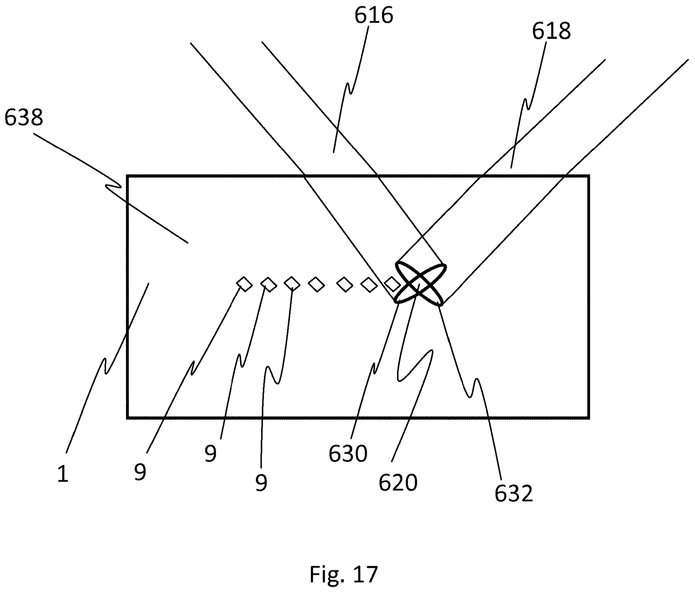

Fig. 17 zeigt die Modifikationserzeugung mittels zweier Laserstrahlen oder zweier Laserstrahlanteile in einer schematischen Darstellung. Die Modifikationen 9 weisen hierbei bevorzugt eine vertikale Ausdehnung von weniger als 50 µm und bevorzugt von weniger als 30 µm und besonders bevorzugt von weniger als 20 µm auf.

Der Fokus 620 ist bevorzugt weniger als 1000 µm und bevorzugt weniger als 500 µm und besonders bevorzugt weniger als 200 µm von einer Eindringoberfläche 626 des Festkörpers 1 beabstandet ist, wobei zumindest einzelne Lichtstrahlanteile 616, 618 über die Eindringoberfläche 626 zum Erzeugen der physischen Modifikation 9 in den Festkörper 1 eindringen.

Der Fokus 620 wird bevorzugt in einem Überlagerungsanteil von zumindest zwei sich kreuzenden Lichtstrahltaillen 630, 632 erzeugt, wobei die Lichtstrahltaillen 630, 632 durch die Lichtstrahlanteile 616, 618 oder Lichtstrahlen 606 erzeugt werden.

Somit wird ein Verfahren zum Erzeugen eines Ablösebereichs in einem Festkörper, insbesondere zum Teilen des Festkörpers entlang des Ablösebereichs beschrieben, wobei der abzulösende Festkörperanteil dünner ist als der um den Festkörperanteil reduzierte Festkörper, mindestens umfassend die Schritte: Modifizieren des Kristallgitters des Festkörpers mittels eines Modifiziermittels, insbesondere mittels zumindest eines Lasers, insbesondere eines Piko- oder Femtosekunden-Laser, wobei die Modifikationen, insbesondere die Laserstrahlen, über eine Oberfläche des abzulösenden Festkörperanteils in den Festkörper eindringen, wobei mehrere Modifikationen in dem Kristallgitter erzeugt werden, wobei das Kristallgitter in Folge der Modifikationen in den die Modifikationen umgebenden Bereichen zumindest in jeweils einem Anteil einreist.

Ferner wird ein Verfahren zum Erzeugen eines Ablösebereichs (2) in einem Festkörper (1), insbesondere zum Teilen des Festkörpers (1) entlang des Ablösebereichs (2) beschrieben, mindestens umfassend die Schritte: Modifizieren des Kristallgitters des Festkörpers (1) mittels eines Modifiziermittels, insbesondere mittels zumindest eines Lasers, insbesondere eines Piko- oder Femtosekunden-Laser, wobei mehrere Modifikationen (9) in dem Kristallgitter erzeugt werden, wobei das Kristallgitter in Folge der Modifikationen (9) in den die Modifikationen (9) umgebenden Bereichen zumindest in jeweils einem Anteil einreist.

Weitere Grundlagen für die Patentansprüche sowie weitere Aspekte dieser Offenbarung sind wie folgt:
1. Verfahren zum Erzeugen eines Ablösebereichs (2) in einem Festkörper (1),
   insbesondere zum Teilen des Festkörpers (1) entlang des Ablösebereichs (2), wobei der abzulösende Festkörperanteil (12) dünner ist als der um den Festkörperanteil (12) reduzierte Festkörper (1),
   mindestens umfassend die Schritte:
      Modifizieren des Kristallgitters des Festkörpers (1) mittels eines Modifiziermittels, insbesondere mittels zumindest eines Lasers, insbesondere eines Piko- oder Femtosekunden-Laser,
      wobei die Modifikationen, insbesondere die Laserstrahlen, über eine Oberfläche (5) des abzulösenden Festkörperanteils (12) in den Festkörper (1) eindringen,
      wobei mehrere Modifikationen (9) in dem Kristallgitter erzeugt werden,
      wobei das Kristallgitter in Folge der Modifikationen (9) in den die Modifikationen (9) umgebenden Bereichen zumindest in jeweils einem Anteil einreist.
2. Verfahren zum Erzeugen eines Ablösebereichs (2) in einem Festkörper (1),
   insbesondere zum Teilen des Festkörpers (1) entlang des Ablösebereichs (2),
   mindesten umfassend die Schritte:
      Modifizieren des Kristallgitters des Festkörpers (1) mittels einer Beaufschlagung durch ein Modifiziermittel, insbesondere mittels zumindest eines Lasers, insbesondere eines Piko- oder Femtosekunden-Laser, wobei mehrere Modifikationen (9) in dem Kristallgitter erzeugt werden,
      Konditionieren zumindest mehrerer der Modifikationen (9) durch ein Konditioniermittel, insbesondere eine Temperierungseinrichtung, wobei das Kristallgitter durch die Konditionierung in den die Modifikation umgebenden Bereichen zumindest in jeweils einem Anteil einreist.
3. Verfahren nach Ziffer 1 oder Ziffer 2,
   dadurch gekennzeichnet, dass
   das Kristallgitter zumindest mehrheitlich in einem vom Zentrum (Z) der jeweiligen Modifikation (9) beabstandeten Anteil einreißt.
4. Verfahren nach Ziffer 3,
   dadurch gekennzeichnet, dass
   der Riss (13) zumindest abschnittsweise durch die Mehrzahl der Modifikationen (9) hindurch geht.
5. Verfahren nach Ziffer 3,
   dadurch gekennzeichnet, dass
   der Riss (13) zumindest zu der Mehrzahl der Modifikationen (9) beabstandet verläuft.
6. Verfahren nach einer der Ziffern 3 bis 5,
   dadurch gekennzeichnet, dass
   eine erste Anzahl an Modifikationen (9) mit ihrem Zentrum (Z) einerseits des Ablösebereichs (2) erzeugt werden und eine zweite Anzahl an Modifikationen (9) mit ihrem Zentrum (Z) andererseits des Ablösebereichs (2) erzeugt werden.
7. Verfahren nach einer der vorangegangenen Ziffern,
   dadurch gekennzeichnet, dass
   die Modifikationen mittels Laser erzeugt werden, wobei die Pulsabstände zwischen 0,01 µm und 10 µm vorgesehen werden und/oder Linienabstände zwischen 0,01 µm und 20 µm vorgesehen werden und/oder eine Pulswiederholfrequenz zwischen 16kHz und 1024kHz vorgesehen wird.
8. Verfahren nach einer der vorangegangenen Ziffern,
   dadurch gekennzeichnet, dass
   der Festkörper (1) über eine Festkörperoberfläche (7) mit einer Kühleinrichtung (3) verbunden ist, wobei die Festkörperoberfläche (7), die mit der Kühleinrichtung (3) verbunden ist, parallel oder im Wesentlichen parallel zu der Oberfläche (5) ausgebildet ist, über welche die Laserstrahlen in den Festkörper (1) eindringen,
   wobei die Kühleinrichtung (3) in Abhängigkeit von der Laserbeaufschlagung, insbesondere in Abhängigkeit von der sich durch die Laserbeaufschlagung ergebenden Temperierung des Festkörpers (1), betrieben wird.
9. Verfahren nach Ziffer 8,
   dadurch gekennzeichnet, dass
   die Kühleinrichtung (3) mindestens eine Sensoreinrichtung (69) zum Erfassen der Temperatur des Festkörpers (1) aufweist und in Abhängigkeit eines vorgegebenen Temperaturverlauf die Abkühlung des Festkörpers (1) bewirkt.
10. Verfahren nach einer der Ziffern 8 oder 9,
   dadurch gekennzeichnet, dass
   die Kühleinrichtung (3) an einer Rotationseinrichtung (30) angekoppelt ist und die Kühleinrichtung (3) mit dem daran angeordneten Festkörper (1) während der Modifikationserzeugung mittels der Rotationseinrichtung (30) rotiert wird, insbesondere mit mehr als 100 Umdrehungen pro Minute oder mit mehr als 200 Umdrehungen pro Minute oder mit mehr als 500 Umdrehungen rotiert wird.
11. Verfahren nach einer der vorangegangenen Ziffern,
   dadurch gekennzeichnet, dass
   in zumindest zwei unterschiedlichen Bereichen des Festkörpers (1) die Anzahl der erzeugten Modifikationen (9) je cm² verschieden ist,
      wobei in einem ersten Bereich ein erster Block (91) an Modifikationslinien erzeugt wird, wobei die einzelnen Modifikationen (9) je Linie bevorzugt weniger als 10 µm, insbesondere weniger als 5 µm oder weniger als 3 µm oder weniger als 1 µm oder weniger als 0,5 µm, voneinander beabstandet erzeugt werden
         und
      die einzelnen Linien des ersten Blocks (91) weniger als 20 µm, insbesondere weniger als 15 µm oder weniger als 10 µm oder weniger als 5 µm oder weniger als 1 µm, voneinander beabstandet erzeugt werden,
         wobei durch den ersten Bock (91) an Modifikationen (9) ein erster Teilablösebereich (25) ausgebildet wird
         und
      in einem zweiten Bereich ein zweiter Block (92) an Modifikationslinien erzeugt wird, wobei die einzelnen Modifikationen (9) je Linie bevorzugt weniger als 10 µm, insbesondere weniger als 5 µm oder weniger als 3 µm oder weniger als 1 µm oder weniger als 0,5 µm, voneinander beabstandet erzeugt werden
         und
      die einzelnen Linien des zweiten Blocks (92) weniger als 20 µm, insbesondere weniger als 15 µm oder weniger als 10 µm oder weniger als 5 µm oder weniger als 1 µm, voneinander beabstandet erzeugt werden, wobei durch den zweiten Bock (92) an Modifikationen (9) ein zweiter Teilablösebereich (27) ausgebildet wird,
   wobei der erste Bereich und der zweite Bereich durch einen dritten Bereich voneinander beabstandet sind, wobei in dem dritten Bereich keine oder im Wesentlichen keine Modifikationen oder gegenüber dem ersten oder zweiten Bereich weniger Modifikationen je cm² mittels Laserstrahlen erzeugt werden und der erste Bereich zum zweiten Bereich um mehr als 20 µm, insbesondere mehr als 50 µm oder mehr als 100 µm oder mehr als 150 µm oder mehr als 200 µm, beabstandet ist.
12. Verfahren nach Ziffer 11,
   dadurch gekennzeichnet, dass
   die Modifikationen (9) zumindest im ersten Block (91) und im zweiten Block (92) in Pulsabstände zwischen 0,01 µm und 10 µm erzeugt werden und/oder Linienabstände zwischen 0,01 µm und 20 µm vorgesehen werden und/oder eine Pulswiederholfrequenz zwischen 16kHz und 20 MHz vorgesehen wird.
13. Verfahren zum zumindest teilweisen Teilen eines Festkörpers (1),
   umfassend einen der Gegenstände der Ziffern 1 bis 10,
   dadurch gekennzeichnet, dass
   so viele Modifikationen (9) in dem Kristallgitter erzeugt werden, dass sich die einzelnen Risse zu einem Hauptriss verbinden, durch den der Festkörper (1) zumindest teilweise und bevorzugt vollständig geteilt wird.
14. Verfahren zum zumindest teilweisen Teilen eines Festkörpers,
   umfassend einen der Gegenstände der Ziffern 1 bis 10,
   dadurch gekennzeichnet, dass
   die Modifikationen (9) in einem ersten Abschnitt des Festkörpers (1) erzeugt werden, wodurch sich ein durch die einzelnen Risse erstreckender Hauptriss ausbildet, wobei nach der Ausbildung des Hauptrisses oder infolge der Ausbildung des Hauptrisses weitere Modifikationen in mindestens einem weiteren Abschnitt des Festkörpers (1) erzeugt werden, wobei der Hauptriss durch weitere Risse, die aus den weiteren Modifikationen (9) resultieren, ebenfalls in den mindestens einen weiteren Abschnitt geführt wird.
15. Verfahren nach einer der vorangegangenen Ziffern,
   dadurch gekennzeichnet, dass
   nach der Abtrennung des Festkörperanteils (12) eine erneute Beaufschlagung des Restfestkörpers (1) mit LASER-Strahlung der LASER-Lichtquelle durchgeführt wird,
   wobei die LASER-Strahlung einen vorgegebenen Anteil des Restfestkörpers (1) im Inneren des Festkörpers (1) zur Ausbildung eines Ablösebereichs (2) definiert temperiert, und die in dem vorgegebenen Anteil des Festkörpers (1) erzeugte Temperatur so hoch ist, dass das den vorgegebenen Anteil ausbildende Material eine vorbestimmte Stoffumwandlung erfährt
      oder
   durch die Laserbeaufschlagung nacheinander mehrere Modifikationen (9) in dem Kristallgitter erzeugt werden, wobei das Kristallgitter in Folge der Modifikationen (9) in den die Modifikationen (9) umgebenden Bereichen zumindest in jeweils einem Anteil davon einreist, wobei durch die Risse im Bereich der Modifikationen (9) der Ablösebereich (2) vorgegeben wird oder mehrere Teilablösebereiche (25, 27, 28, 29) vorgegeben werden.

**Bezugszeichenliste:**

| | | | |
|---|---|---|---|
| 1 | Festkörper | 30 | Rotationstisch |
| 2 | Ablösebereich | 31 | Riss zwischen Außenkante und erstem Modifikationsblock |
| 4 | Laserstrahl | | |
| 5 | Polierte Oberfläche | 32 | Riss zwischen zwei Modifikationsblöcken |
| 6 | Laserstrahl im Festkörper | 33 | Riss zwischen Modifikationsblock und weiterem Modifikationsblock oder Außenkante |
| 8 | Fokus | | |
| 9 | Modifikation | | |
| 10 | Erster Festkörperteil | 34 | Riss zwischen Modifikationsblock und Außenkante |
| 12 | Zweiter Festkörperteil | | |
| 13 | Riss | 40 | Optik |
| 14 | Ort des Bearbeitungsstarts | 41 | erste Bereich ohne Modifikationsblock |
| 15 | Zentrum der Modifikationen | 42 | zweiter Bereich ohne |
| 16 | Unterseite des Festkörpers | | Modifikationsblock |
| 17 | Referenzlänge | 43 | dritter Bereich ohne |
| 18 | Hauptoberfläche | | Modifikationsblock |
| 19 | Seitliche Oberfläche | 44 | vierter Bereich ohne Modifikationsblock |
| 20 | Linienabstand zwischen linienmäßig erzeugten Kristallgittermodifikationen | 45 | fünfter Bereich ohne Modifikationsblock |
| 22 | Linienabstand zwischen linienmäßig erzeugten Kristallgittermodifikationen | 51 | unveränderter Stoff |
| | | 52 | veränderter Stoff |
| | | 53 | Ramanspektrum |
| 23 | Weitere Modifikation | 54 | Intensität in % |
| 25 | erster Rissanteil | 56 | Wellenlänge in cm⁻¹ |
| 27 | zweiter Rissanteil | 61 | Graph zum unveränderten Stoffanteil |
| 28 | dritter Rissanteil | | |
| 29 | vierter Rissanteil | | |
| 62 | Graph zu verändertem Stoffanteil | 403 | weiterer Laserstrahlenleiter |
| 65 | erstes Ausrichtelement | 501 | Freigelegte Oberfläche der ersten Festkörperschicht |
| 66 | zweites Ausrichtelement | | |
| 67 | drittes Ausrichtelement | 502 | Lasereindringoberfläche der zweiten Festkörperschicht |
| 68 | viertes Ausrichtelement | 503 | Freigelegte Oberfläche der zweiten |
| 69 | Sensormittel | | Festkörperschicht |
| 75 | Datenträgerelement und/oder Datenübertragungselement | 504 | Lasereindringoberfläche der dritten Festkörperschicht |
| 76 | Nut | 505 | Freigelegte Oberfläche der dritten |
| 77 | Fluideingang | | Festkörperschicht |
| 78 | Fluidleitung | 606 | Lichtstrahl |
| 79 | Fluidausgang | 608 | Optik |
| 80 | Leit-Stütz-Struktur | 610 | erstes Umlenkelement |
| 71 | erstes Ende eines Rissanteils | 612 | zweites Umlenkelement |
| 72 | zweites Ende eines Rissanteils | 613 | drittes Umlenkelement |
| 91 | erster Block an Modifikationen | 616 | erster Lichtstrahlanteil |
| 92 | zweiter Block an Modifikationen | 618 | zweiter Lichtstrahlanteil |
| 112 | zweite Festkörperschicht | 620 | Fokus |
| 113 | dritte Festkörperschicht | 622 | erster Oberflächenanteil |
| 300 | Kopplungsschicht | 624 | zweiter Oberflächenanteil |
| 630 | Lichtstrahltaille | 630 | Lichtstrahltaille |
| 632 | Lichtstrahltaille | 632 | Lichtstrahltaille |
| 400 | Scanner | 901 | erstes Feld ohne Modifikationen |
| 401 | Laserstrahlenquelle | 902 | zweites Feld ohne Modifikationen |
| 402 | Laserstrahlenleiter | 903 | drittes Feld ohne Modifikationen |
| A | Beispiel einer ersten Defektanordnung | | |
| B | Beispiel einer zweiten Defektanordnung | | |
| C | Beispiel einer dritten Defektanordnung | | |
| D | Beispiel einer vierten Defektanordnung | | |
| Z | Zentrum | | |

## Patentansprüche

1. Verfahren zum Erzeugen eines Ablösebereichs (2) in einem Festkörper (1), wobei der Festkörper (1) ein Ingot oder ein Wafer ist, der ein Kristallgitter aufweist und für von einem Laser emittierte Laserstrahlen mindestens teilweise transparent ist, umfassend:
Modifizieren des Kristallgitters des Festkörpers (1) mittels der Laserstrahlen,
wobei die Laserstrahlen durch eine Hauptoberfläche (5, 18) eines abzulösenden Festkörperanteils (12) in den Festkörper (1) eindringen,
wobei mehrere Modifikationen (9) in dem Kristallgitter erzeugt werden,
wobei die Modifikationen (9) in einer Ebene parallel zur Hauptoberfläche (5) und in einem Abstand zueinander ausgebildet werden,
wobei das Kristallgitter in Folge der Modifikationen (9) in die Modifikationen (9) umgebenden Bereichen zumindest in jeweils einem Anteil einreißt,
wobei sich in einer Ebene parallel zu der Hauptoberfläche (5) unterkritische Risse ausbreiten.

2. Verfahren nach Anspruch 1, wobei
der Riss (13) zumindest abschnittsweise durch die Mehrzahl der Modifikationen (9) hindurch geht.

3. Verfahren nach Anspruch 1, wobei
das Kristallgitter zumindest mehrheitlich in einem vom Zentrum (Z) der jeweiligen Modifikation (9) beabstandeten Anteil einreißt.

4. Verfahren nach Anspruch 3, wobei
der Riss (13) zumindest zu der Mehrzahl der Modifikationen (9) beabstandet verläuft.

5. Verfahren nach einem der Ansprüche 2 bis 4, wobei
eine erste Anzahl an Modifikationen (9) mit ihrem Zentrum (Z) einerseits des Ablösebereichs (2) erzeugt werden und eine zweite Anzahl an Modifikationen (9) mit ihrem Zentrum (Z) andererseits des Ablösebereichs (2) erzeugt werden.

6. Verfahren nach einem der vorangegangenen Ansprüche, wobei
die Modifikationen mittels gepulster Laserstrahlung mit Pulsabständen zwischen 0,01 µm und 10 µm und/oder mit einer Pulswiederholfrequenz zwischen 16kHz und 1024kHz erzeugt und/oder mit Linienabständen zwischen 0,01 µm und 20 µm ausgebildet werden.

7. Verfahren nach einem der vorangegangenen Ansprüche, wobei
der Festkörper (1) über eine Festkörperoberfläche (7) mit einer Kühleinrichtung (3) verbunden ist, wobei die Festkörperoberfläche (7), die mit der Kühleinrichtung (3) verbunden ist, parallel oder im Wesentlichen parallel zu der Hauptoberfläche (5) ausgebildet ist, über welche die Laserstrahlen in den Festkörper (1) eindringen,
wobei die Kühleinrichtung (3) in Abhängigkeit von der Laserbeaufschlagung, insbesondere in Abhängigkeit von der sich durch die Laserbeaufschlagung ergebenden Temperierung des Festkörpers (1), betrieben wird.

8. Verfahren nach Anspruch 7, wobei
die Kühleinrichtung (3) mindestens eine Sensoreinrichtung (69) zum Erfassen der Temperatur des Festkörpers (1) aufweist und in Abhängigkeit eines vorgegebenen Temperaturverlaufs eine Abkühlung des Festkörpers (1) bewirkt.

9. Verfahren nach einem der Ansprüche 7 oder 8, wobei
die Kühleinrichtung (3) an einer Rotationseinrichtung (30) angekoppelt ist und die Kühleinrichtung (3) mit dem daran angeordneten Festkörper (1) während der Modifikationserzeugung mittels der Rotationseinrichtung (30) rotiert wird, insbesondere mit mehr als 100 Umdrehungen pro Minute oder mit mehr als 200 Umdrehungen pro Minute oder mit mehr als 500 Umdrehungen rotiert wird.

10. Verfahren nach einem der vorangegangenen Ansprüche,
wobei in zumindest zwei unterschiedlichen Bereichen des Festkörpers (1) die Anzahl der erzeugten Modifikationen (9) je cm² verschieden ist,
wobei in einem ersten Bereich ein erster Block (91) an Modifikationslinien erzeugt wird, wobei die einzelnen Modifikationen (9) je Linie (20, 22) bevorzugt weniger als 10 µm, insbesondere weniger als 5 µm oder weniger als 3 µm oder weniger als 1 µm oder weniger als 0,5 µm, voneinander beabstandet erzeugt werden,
wobei die Linien des ersten Blocks (91) weniger als 20 µm, insbesondere weniger als 15 µm oder weniger als 10 µm oder weniger als 5 µm oder weniger als 1 µm, voneinander beabstandet erzeugt werden, wobei durch den ersten Bock (91) an Modifikationen (9) ein erster Teilablösebereich (25) ausgebildet wird
und
wobei in einem zweiten Bereich ein zweiter Block (92) an Modifikationslinien erzeugt wird,
wobei die einzelnen Modifikationen (9) je Linie bevorzugt weniger als 10 µm, insbesondere weniger als 5 µm oder weniger als 3 µm oder weniger als 1 µm oder weniger als 0,5 µm, voneinander beabstandet erzeugt werden
wobei die Linien des zweiten Blocks (92) weniger als 20 µm, insbesondere weniger als 15 µm oder weniger als 10 µm oder weniger als 5 µm oder weniger als 1 µm, voneinander beabstandet erzeugt werden, wobei durch den zweiten Bock (92) an Modifikationen (9) ein zweiter Teilablösebereich (27) ausgebildet wird,
wobei der erste Bereich und der zweite Bereich durch einen dritten Bereich voneinander beabstandet sind,
wobei in dem dritten Bereich keine oder im Wesentlichen keine Modifikationen oder gegenüber dem ersten oder zweiten Bereich weniger Modifikationen je cm² mittels Laserstrahlen erzeugt werden und
wobei der erste Bereich zum zweiten Bereich um mehr als 20 µm, insbesondere mehr als 50 µm oder mehr als 100 µm oder mehr als 150 µm oder mehr als 200 µm, beabstandet ist.

11. Verfahren nach Anspruch 10, **dadurch gekennzeichnet, dass**
die Modifikationen (9) zumindest im ersten Block (91) und im zweiten Block (92) mittels gepulster Laserstrahlung mit Pulsabständen zwischen 0,01 µm und 10 µm und/oder einer Pulswiederholfrequenz zwischen 16kHz und 20 MHz erzeugt und die Modifikationen (9) mit Linienabständen zwischen 0,01 µm und 20 µm ausgebildet werden.

12. Verfahren zum zumindest teilweisen Teilen eines Festkörpers (1), umfassend das Verfahren nach einem der Ansprüche 1 bis 9,
wobei so viele Modifikationen (9) in dem Kristallgitter erzeugt werden, dass sich die einzelnen Risse zu einem Hauptriss verbinden, durch den der Festkörper (1) zumindest teilweise und bevorzugt vollständig geteilt wird.

13. Verfahren zum zumindest teilweisen Teilen eines Festkörpers (1), umfassend das Verfahren nach einem der Ansprüche 1 bis 9,
wobei die Modifikationen (9) in einem ersten Abschnitt des Festkörpers (1) erzeugt werden, wodurch sich ein durch die einzelnen Risse erstreckender Hauptriss ausbildet, wobei nach der Ausbildung des Hauptrisses oder infolge der Ausbildung des Hauptrisses weitere Modifikationen in mindestens einem weiteren Abschnitt des Festkörpers (1) erzeugt werden, wobei der Hauptriss durch weitere Risse, die aus den weiteren Modifikationen (9) resultieren, ebenfalls in den mindestens einen weiteren Abschnitt geführt wird.

14. Verfahren nach einem der vorangegangenen Ansprüche,
wobei nach der Abtrennung des Festkörperanteils (12) eine erneute Beaufschlagung des Restfestkörpers (1) mit LASER-Strahlung der LASER-Lichtquelle durchgeführt wird,
wobei die LASER-Strahlung einen vorgegebenen Anteil des Restfestkörpers (1) im Inneren des Festkörpers (1) zur Ausbildung eines Ablösebereichs (2) definiert temperiert, und die in dem vorgegebenen Anteil des Festkörpers (1) erzeugte Temperatur so hoch ist, dass das den vorgegebenen Anteil ausbildende Material eine vorbestimmte Stoffumwandlung erfährt,
oder
durch die Laserbeaufschlagung nacheinander mehrere Modifikationen (9) in dem Kristallgitter erzeugt werden, wobei das Kristallgitter in Folge der Modifikationen (9) in den die Modifikationen (9) umgebenden Bereichen zumindest in jeweils einem Anteil davon einreißt, wobei durch die Risse im Bereich der Modifikationen (9) der Ablösebereich (2) vorgegeben wird oder mehrere Teilablösebereiche (25, 27, 28, 29) vorgegeben werden.

## Claims

1. Method for producing a detachment region (2) in a solid (1), the solid (1) being an ingot or a wafer which has a crystal lattice and is at least partially transparent to laser beams emitted by a laser, comprising:
modifying the crystal lattice of the solid (1) by means of the laser beams,
wherein the laser beams penetrate into the solid (1) through a main surface (5, 18) of a portion (12) of the solid that is to be detached,
wherein multiple modifications (9) are produced in the crystal lattice,
wherein the modifications (9) are formed in a plane parallel to the main surface (5) and at a distance from one another,
wherein, as a result of the modifications (9), the crystal lattice cracks in regions surrounding the modifications (9), at least in one portion in each case, wherein subcritical cracks propagate in a plane parallel to the main surface (5).

2. Method according to Claim **1,** wherein
the crack (13) passes at least partly through the majority of the modifications (9).

3. Method according to Claim **1,** wherein
the crystal lattice cracks at least for the most part in a portion spaced apart from the centre (Z) of the respective modification (9).

4. Method according to Claim 3, wherein
the crack (13) runs at a distance from at least the majority of the modifications (9).

5. Method according to one of Claims 2 to 4, wherein
a first number of modifications (9) are produced with their centre (Z) on one side of the detachment region (2) and a second number of modifications (9) are produced with their centre (Z) on the other side of the detachment region (2).

6. Method according to one of the preceding claims, wherein
the modifications are produced by means of pulsed laser radiation with pulse intervals of between 0.01 µm and 10 µm and/or with a pulse repetition frequency of between 16 kHz and 1024 kHz and/or are formed with line spacings of between 0.01 µm and 20 µm.

7. Method according to one of the preceding claims, wherein
the solid (1) is connected to a cooling device (3) by means of a surface (7) of the solid, wherein the surface (7) of the solid that is connected to the cooling device (3) is formed parallel or substantially parallel to the main surface (5) via which the laser beams penetrate into the solid (1),
wherein the cooling device (3) is operated in dependence on the exposure to the laser, in particular in dependence on the temperature adjustment of the solid (1) resulting from the exposure to the laser.

8. Method according to Claim 7, wherein
the cooling device (3) has at least one sensor device (69) for detecting the temperature of the solid (1) and brings about a cooling of the solid (1) in dependence on a predetermined temperature profile.

9. Method according to either of Claims 7 or 8, wherein the cooling device (3) is coupled to a rotating device (30) and, during the production of the modifications, the cooling device (3) with the solid (1) arranged on it is rotated by means of the rotating device (30), in particular is rotated at more than 100 revolutions per minute or at more than 200 revolutions per minute or more than 500 revolutions.

10. Method according to one of the preceding claims, wherein, in at least two different regions of the solid (1), the number of modifications (9) produced per cm² is different,
wherein, in a first region, a first block (91) of modification lines is produced,
wherein the individual modifications (9) per line (20, 22) are produced preferably spaced apart from one another by less than 10 µm, in particular less than 5 µm or less than 3 µm or less than 1 µm or less than 0.5 µm,
wherein the lines of the first block (91) are produced spaced apart from one another by less than 20 µm, in particular less than 15 µm or less than 10 µm or less than 5 µm or less than 1 µm, wherein a first partial detachment region (25) is formed by the first block (91) of modifications (9)
and
wherein, in a second region, a second block (92) of modification lines is produced,
wherein the individual modifications (9) per line are produced preferably spaced apart from one another by less than 10 µm, in particular less than 5 µm or less than 3 µm or less than 1 µm or less than 0.5 µm,
wherein the lines of the second block (92) are produced spaced apart from one another by less than 20 µm, in particular less than 15 µm or less than 10 µm or less than 5 µm or less than 1 µm, wherein a second partial detachment region (27) is formed by the second block (92) of modifications (9),
wherein the first region and the second region are spaced apart from one another by a third region,
wherein, in the third region, no or substantially no modifications or fewer modifications per cm² compared with the first or second region are produced by means of laser beams and
wherein the first region is spaced apart from the second region by more than 20 µm, in particular more than 50 µm or more than 100 µm or more than 150 µm or more than 200 µm.

11. Method according to Claim 10, **characterized in that** the modifications (9) at least in the first block (91) and in the second block (92) are produced by means of pulsed laser radiation with pulse intervals of between 0.01 µm and 10 µm and/or a pulse repetition frequency of between 16 kHz and 20 MHz and the modifications (9) are formed with line spacings of between 0.01 µm and 20 µm.

12. Method for at least partially splitting a solid (1), comprising the method according to one of Claims 1 to 9, wherein enough modifications (9) are produced in the crystal lattice for the individual cracks to combine to form a main crack through which the solid (1) is at least partially and preferably completely split.

13. Method for at least partially splitting a solid (1), comprising the method according to one of Claims 1 to 9, wherein the modifications (9) are produced in a first portion of the solid (1), with the result that a main crack extending through the individual cracks is formed, wherein, after the formation of the main crack or as a result of the formation of the main crack, further modifications are produced in at least one further portion of the solid (1), wherein the main crack is led likewise into the at least one further portion by further cracks resulting from the further modifications (9).

14. Method according to one of the preceding claims, wherein, after the separation of the portion (12) of the solid, the remaining solid (1) is subjected to renewed exposure to LASER radiation from the LASER light source, wherein the LASER radiation adjusts the temperature of a predetermined portion of the remaining solid (1) in the interior of the solid (1) in a defined manner to form a detachment region (2), and the temperature established in the predetermined portion of the solid (1) is high enough that the material forming the predetermined portion undergoes a predetermined material conversion, or
as a result of the laser exposure, multiple modifications (9) are produced successively in the crystal lattice, wherein, as a result of the modifications (9), the crystal lattice cracks in the regions surrounding the modifications (9), at least in one portion in each case, wherein the detachment region (2) is predetermined by the cracks in the region of the modifications (9) or multiple partial detachment regions (25, 27, 28, 29) are predetermined.

## Revendications

1. Procédé de production d'une zone (2) à détacher dans un corps (1) solide, dans lequel le corps (1) solide est un lingot ou une tranche, qui a un réseau cristallin et qui est transparent au moins en partie à un faisceau laser émis par un laser, comprenant :
modification du réseau cristallin du corps (1) solide au moyen du faisceau laser,
dans lequel le faisceau laser pénètre dans le corps (1) solide par une surface (5, 18) principale d'une partie (12) à détacher du corps (1) solide,
dans lequel on produit plusieurs modifications (9) dans le réseau cristallin,
dans lequel on constitue les modifications (9) dans un plan parallèlement à la surface (5) principale et à distance les unes des autres, et
dans lequel le réseau cristallin se déchire au moins dans respectivement une partie dans les zones entourant les modifications (9) en raison des modifications (9),
dans lequel des fissures sous-critiques se propagent dans un plan parallèle à la surface (5) principale.

2. Procédé suivant la revendication 1, dans lequel
la fissure (13) passe au moins par endroits dans la pluralité des modifications (9).

3. Procédé suivant la revendication 1, dans lequel
le réseau cristallin se déchire au moins majoritairement dans une partie à distance du centre (Z) de la modification (9) respective.

4. Procédé suivant la revendication 3, dans lequel
la fissure (13) s'étend au moins à distance de la pluralité des modifications (9).

5. Procédé suivant l'une des revendications 2 à 4, dans lequel on produit un premier nombre de modifications (9) ayant leur centre (Z) d'un côté de la zone (2) à détacher et un deuxième nombre de modifications (9) ayant leur centre (Z) de l'autre côté de la zone (2) à détacher.

6. Procédé suivant l'une des revendications précédentes, dans lequel
on produit les modifications au moyen d'un rayonnement laser pulsé ayant des distances entre les impulsions comprises entre 0,01 µm et 10 µm et/ou avec une fréquence de répétition des impulsions comprise entre 16 kHz et 1024 kHz et/ou on forme des distances linéaires comprises entre 0,01 µm et 20 µm.

7. Procédé suivant l'une des revendications précédentes, dans lequel
le corps (1) solide est, par une surface (7) du corps solide, relié à un dispositif (3) de refroidissement, dans lequel la surface (7) du corps solide, qui est reliée au dispositif (3) de refroidissement, est parallèle ou sensiblement parallèle à la surface (5) principale, par laquelle le faisceau laser pénètre dans le corps (1) solide,
dans lequel on fait fonctionner le dispositif (3) de refroidissement en fonction de l'alimentation laser, en particulier en fonction de la mise en température du corps (1) solide provenant de l'alimentation du laser.

8. Procédé suivant la revendication 7, dans lequel
le dispositif (3) de refroidissement a au moins un dispositif (69) capteur pour relever la température du corps (1) solide et provoque, en fonction d'une courbe de température donnée à l'avance, un refroidissement du corps (1) solide.

9. Procédé suivant l'une des revendications 7 ou 8, dans lequel le dispositif (3) de refroidissement est accouplé à un dispositif (30) de rotation et on fait tourner, au moyen du dispositif (30) de rotation, le dispositif (3) de refroidissement avec le corps (1) solide, qui y est disposé, pendant la production de la modification, en particulier on le fait tourner à plus de 100 tours à la minute ou à plus de 200 tours à la minute ou à plus de 500 tours à la minute.

10. Procédé suivant l'une des revendications précédentes, dans lequel,
dans au moins deux zones différentes du corps (1) solide, le nombre des modifications (9) produites par cm² est différent,
dans lequel, dans une première zone, on produit un premier bloc (91) de lignes de modification,
dans lequel on produit les diverses modifications (9) par ligne (20, 22), de préférence à une distance les unes des autres de moins de 10 µm, en particulier de moins de 5 µm ou de moins de 3 µm ou de moins de 0,5 µm,
dans lequel on produit les lignes du premier bloc (91) à une distance les unes des autres de moins de 20 µm, en particulier de moins de 15 µm ou de moins de 10 µm ou de moins de 5 µm ou de moins de 1 µm, dans lequel on forme une première zone (25) partielle à détacher par le premier bloc (91) de modifications (9),
et
dans lequel, dans une deuxième zone, on produit un deuxième bloc (92) de lignes de modification,
dans lequel on produit les diverses modifications (9) par ligne, de préférence à une distance les unes des autres de moins de 10 µm, en particulier de moins de 5 µm ou de moins de 3 µm ou de moins de 0,5 µm,
dans lequel on produit les lignes du deuxième bloc (92) à une distance les unes des autres de moins de 20 µm, en particulier de moins de 15 µm ou de moins de 10 µm ou de moins de 5 µm ou de moins de 1 µm, dans lequel on forme une deuxième zone (27) partielle à détacher par le deuxième bloc (92) de modification,
dans lequel la première zone et la deuxième zone sont à distance l'une de l'autre par une troisième zone,
dans lequel on ne produit, au moyen du faisceau laser dans la troisième zone, pas ou sensiblement pas de modifications ou, par rapport à la première et à la deuxième zones, moins de modifications par cm², et
dans lequel la première zone est à une distance de la deuxième zone de plus de 20 µm, en particulier de plus de plus de 50 µm ou de plus de 100 µm ou de plus de 150 µm ou de plus de 200 µm.

11. Procédé suivant la revendication 10, **caractérisé en ce que** l'on produit les modifications (9) au moins dans le premier bloc (91) et dans le deuxième bloc (92) au moyen d'un rayonnement laser pulsé ayant des distances entre impulsions comprises entre 0,01 µm et 10 µm et/ou ayant une fréquence de répétitions d'impulsions comprise entre 16 kHz et 20 MHz et on forme les modifications (9) avec des distances linéaires comprises entre 0,01 µm et 20 µm.

12. Procédé de subdivision au moins partielle d'un corps (1) solide comprenant le procédé suivant l'une des revendications 1 à 9,
dans lequel on produit tant de modifications (9) dans le réseau cristallin que les diverses fissures se relient en une fissure principale, par laquelle le corps (1) solide est subdivisé au moins en partie et de préférence complètement.

13. Procédé de subdivision au moins partielle d'un corps (1) solide comprenant le procédé suivant l'une des revendications 1 à 9,
dans lequel on produit une modification (9) dans une première partie du corps (1) solide, grâce à quoi on forme une fissure principale s'étendant dans les diverses fissures, dans lequel, après la formation de la fissure principale ou en raison de la formation de la fissure principale, on produit d'autres modifications dans au moins une autre partie du corps (1) solide, dans lequel on fait passer, également dans la au moins une autre partie, la fissure principale par d'autres fissures, qui proviennent des autres modifications (9).

14. Procédé suivant l'une des revendications précédentes,
dans lequel, après la séparation de la partie (12) du corps solide, on soumet à nouveau le corps (1) solide restant à du rayonnement laser de la source de lumière laser,
dans lequel, le rayonnement laser met en température de manière définie une partie donnée à l'avance du corps (1) solide restant à l'intérieur du corps (1) pour la formation d'une zone (2) à détacher et la température produite dans la partie donnée à l'avance du corps (1) solide est si haute que le matériau constituant la partie donnée à l'avance subit une transformation de matière déterminée à l'avance,
ou
par l'alimentation laser, on produit les unes après les autres plusieurs modifications (9) dans le réseau cristallin, dans lequel le réseau cristallin se déchire en raison des modifications (9) dans les zones entourant les modifications (9) au moins en respectivement une partie, dans lequel on prescrit la zone (2) à détacher ou plusieurs zones (25, 27, 28, 29) partielles à détacher par les fissures dans la zone des modifications (9).
